# EUROPEAN PATENT APPLICATION

(11) **EP 4 750 248 A1**
(43) Date of publication of application: **27.05.2026**
(21) Application number: 25169308.1
(22) Date of filing: 09.04.2025
(51) Int. Cl.: H10D 30/01, H10D 30/66, H10D 62/10, H10D 64/00

(54) **METHODS FOR MANUFACTURING SEMICONDUCTOR DEVICES HAVING MULTIPLE SHIELD ELECTRODES AND STRUCTURES**

(30) Priority: 21.11.2024 US 202418955469
(71) Applicant: Semiconductor Components Industries, LLC, Scottsdale, AZ 85250 (US)
(72) Inventor: TANIGUCHI, Toshimitsu, Fukushima, 965 0835 (JP); BURKE, Peter A., Portland, OR, 97212 (US)
(74) Representative: Manitz Finsterwald Patent- und Rechtsanwaltspartnerschaft mbB

(57) **Abstract**

A method of manufacturing a semiconductor device includes providing a region of semiconductor material including a top side, an edge region, a multiple shield conductor contact area within the edge region, an active area, and an upper shield contact area. The method includes providing an active trench. The active trench includes a lower shield conductor, a first shield dielectric isolating the lower shield conductor from the region of semiconductor material, an upper shield conductor, and a second shield dielectric isolating the lower shield conductor from the upper shield conductor within the active area. The lower shield conductor and the upper shield conductor are coupled together in the multiple shield conductor contact area. The method includes providing a shield contact in the upper shield contact area coupled to the upper shield conductor in the active trench.

## Description

### Cross-Reference to Related Applications

Not applicable.

### Technical Field

The present disclosure relates, in general, to electronics and, more particularly, to semiconductor device structures and methods of forming semiconductor devices.

### Background

Insulated gate field effect transistors (IGFETs), such as metal oxide semiconductor field effect transistors (MOSFETs), have been used in many power switching applications, such as dc-dc converters. In a typical MOSFET, a gate electrode provides turn-on and turn-off control with the application of an appropriate gate voltage. By way of example, in an N-type enhancement mode MOSFET, turn-on occurs when a conductive N-type inversion layer (i.e., channel region) is formed in a P-type body region in response to the application of a positive gate voltage, which exceeds an inherent threshold voltage. The inversion layer connects N-type source regions to N-type drain regions and allows for majority carrier conduction between these regions.

There is a class of MOSFET devices in which the gate electrode is formed in a trench extending downward from a major surface of a semiconductor material, such as silicon. Current flow in such trench gate MOSFET devices is primarily in a vertical direction through the device, and, as a result, device cells can be more densely packed. All else being equal, the more densely packed device cells can increase the current carrying capability and reduce on-resistance of the device.

A variation of trench gate MOSFETs includes shielded-gate MOSFETs that place a shield electrode within the trench below and electrically isolated from the gate electrode. In some examples, the shield electrode can be connected to source potential. With the shield electrode electrically isolated from the drift region by a thicker dielectric compared to the gate dielectric, a charge balance effect is provided for the drift region. This enables a higher doping within the drift region, resulting in reduced on-resistance. In addition, the shield electrode functions to shield the gate electrode from the drift region, which reduces gate-to-drain capacitance C_{gd} and improves switching performance.

In some applications, multiple shield electrodes have been used to for vertical charge control purposes to improve smaller forward voltage loss and higher blocking capability. However, manufacturing challenges have made it difficult to implement semiconductor devices, such as MOSFET devices, with multiple shield electrodes.

Accordingly, methods and structures are needed for manufacturing semiconductor devices comprising multiple shield electrodes. In addition, methods and structures are needed for providing electrical contact to the multiple shield electrodes, which are separated by a dielectric.

### Brief Description of the Drawings

FIG. 1 illustrates a partial top plan view of an example cell topography of a semiconductor device in accordance with the present description;
FIG. 2 illustrates a partial cross-sectional view of a portion of the semiconductor device of the example cell topography of FIG. 1 taken along reference line 2A-2A;
FIG. 3 illustrates a partial cross-sectional view of a portion of the semiconductor device of the example cell topography of FIG. 1 taken along reference line 3A-3A;
FIG. 4 illustrates a partial cross-sectional view of a portion of the semiconductor device of the example cell topography of FIG. 1 taken along reference line 4A-4A;
FIGS. 5, 6, 7, 8, 9, 10, 11, 12, 13, 14, 15, 16, 17, 18, 19, and 20 illustrate partial cross-sectional views of a semiconductor device at various stages of fabrication in accordance with the present description;
FIG. 21 illustrates a partial cross-sectional view of a portion of the semiconductor device of the example cell topography of FIG. 1 taken along reference line 21A"-21A";
FIG. 22 illustrates a partial cross-section view of a portion of a semiconductor device in accordance with the present description; and
FIGS. 23, 24, 25, 26, 27, and 28 illustrate partial cross-sectional views of a semiconductor device at various stages of fabrication taken along reference line 23A-23A of FIG. 1 in accordance with the present description.

The following discussion provides various examples of semiconductor devices and methods of manufacturing semiconductor devices. Such examples are non-limiting, and the scope of the appended claims should not be limited to the particular examples disclosed. In the following discussion, the terms "example" and "e.g." are non-limiting.

For simplicity and clarity of the illustration, elements in the figures are not necessarily drawn to scale, and the same reference numbers in different figures denote the same elements. Additionally, descriptions and details of well-known steps and elements are omitted for simplicity of the description.

For clarity of the drawings, certain regions of device structures, such as doped regions or dielectric regions, trenches, or contacts may be illustrated as having generally straight-line edges and precise angular corners. However, those skilled in the art understand that, due to the diffusion and activation of dopants or formation of layers, the edges of such regions generally may not be straight lines and that the corners may not be precise angles.

Although the semiconductor devices are explained herein as certain N-type conductivity regions and certain P-type conductivity regions, a person of ordinary skill in the art understands that the conductivity types can be reversed and are also possible in accordance with the present description, considering any necessary polarity reversal of voltages, inversion of transistor type and/or current direction, etc.

In addition, the terminology used herein is for the purpose of describing particular examples only and is not intended to be limiting of the disclosure. As used herein, the singular forms are intended to include the plural forms as well, unless the context clearly indicates otherwise.

As used herein, "current-carrying electrode" means an element of a device that carries current through the device, such as a source or a drain of an MOS transistor, an emitter or a collector of a bipolar transistor, or a cathode or anode of a diode, and a "control electrode" means an element of the device that controls current through the device, such as a gate of a MOS transistor or a base of a bipolar transistor.

The term "major surface" when used in conjunction with a semiconductor region, wafer, or substrate means the surface of the semiconductor region, wafer, or substrate that forms an interface with another material, such as a dielectric, an insulator, a conductor, or a polycrystalline semiconductor. The major surface can have a topography that changes in the x, y and z directions.

In addition, structures of the present description can embody either a cellular-base design (in which the body regions are a plurality of distinct and separate cellular or stripe regions) or a single-base design (in which the body region is a single region formed in an elongated pattern, typically in a serpentine pattern or a central portion with connected appendages). However, one embodiment of the present description will be described as a cellular base design throughout the description for ease of understanding. It is understood that the present description encompasses both a cellular-base design and a single-base design.

The terms "comprises", "comprising", "includes", "including", "has", "have" and/or "having" when used in this description, are open ended terms that specify the presence of stated features, numbers, steps, operations, elements, and/or components, but do not preclude the presence or addition of one or more other features, numbers, steps, operations, elements, components, and/or groups thereof.

The term "or" means any one or more of the items in the list joined by "or". As an example, "x or y" means any element of the three-element set {(x), (y), (x, y)}. As another example, "x, y, or z" means any element of the seven-element set {(x), (y), (z), (x, y), (x, z), (y, z), (x, y, z)}.

The term "step" when used in this description means one or more unit processes used to manufacture a semiconductor device and can include multiple or a series of unit processes within a process step, such as an etch step, a photoresist masking step, a deposition step, or a doping step. Such unit processes can include, but are not limited to, cleaning processes, drying processes, exposure processes, developing processes, stripping processes, and those unit processes commonly used within a process step.

Although the terms "first", "second", etc. may be used herein to describe various members, elements, regions, layers and/or sections, these members, elements, regions, layers and/or sections should not be limited by these terms. These terms are only used to distinguish one member, element, region, layer and/or section from another. Thus, for example, a first member, a first element, a first region, a first layer and/or a first section discussed below could be termed a second member, a second element, a second region, a second layer and/or a second section without departing from the teachings of the present disclosure.

It will be appreciated by one skilled in the art that words, "during", "while", and "when" as used herein related to circuit operation are not exact terms that mean an action takes place instantly upon an initiating action but that there may be some small but reasonable delay, such as propagation delay, between the reaction that is initiated by the initial action. Additionally, the term "while" means a certain action occurs at least within some portion of a duration of the initiating action.

The use of word "about", "approximately", or "substantially" means a value of an element is expected to be close to a state value or position. However, as is well known in the art there are always minor variances preventing values or positions from being exactly stated.

Unless specified otherwise, as used herein, the word "over" or "on" includes orientations, placements, or relations where the specified elements can be in direct or indirect physical contact.

Unless specified otherwise, as used herein, the word "overlapping" includes orientations, placements, or relations where the specified elements can at least partly or wholly coincide or align in the same or different planes.

It is further understood that the examples illustrated and described hereinafter suitably may have examples and/or may be practiced in the absence of any element that is not specifically disclosed herein.

### Detailed Description

In general, the present examples relate to semiconductor device structures and methods of making semiconductor devices, including trench gate MOSFET devices with multiple shield electrodes, having improved manufacturability and performance. In some examples, structures including cell topography structures are described that facilitate electrical connection between multiple shield electrodes. Such structures can be provided, for example, at tip portions of active trenches. In some examples, such structures can be provided at end portions of termination trenches that wrap around the tip portions of the active trenches. In some examples, methods are described that improve the manufacturability of electrical connection structures between multiple shield electrodes and electrical connections to the termination trenches, which improve the overall reliability of the semiconductor device. Such method includes using a negative photoresist when preparing to remove portions of shield dielectrics and using a multi-step removal process when providing upper shield conductors. In addition, the methods and structures simplify the interconnection scheme between the shield conductors, which saves layout space, simplifies the cell topography, and reduces impact on die size. Further advantages and benefits will be apparent to one of ordinary skill in the art based on the following description.

In an example, a method of manufacturing a semiconductor device includes providing a region of semiconductor material including a top side, an edge region, a multiple shield conductor contact area within the edge region, an active area, and an upper shield contact area. The method includes providing an active trench extending from the top side into the region of semiconductor material. The active trench includes a lower shield conductor, a first shield dielectric isolating the lower shield conductor from the region of semiconductor material, an upper shield conductor, and a second shield dielectric isolating the lower shield conductor from the upper shield conductor within the active area. The active trench laterally extends within the region of semiconductor material from the active area into the multiple shield conductor contact area, and the lower shield conductor and the upper shield conductor are coupled together in the multiple shield conductor contact area. The method includes providing a shield contact in the upper shield contact area coupled to the upper shield conductor in the active trench.

In an example, a method of manufacturing a semiconductor device includes providing a region of semiconductor material including a top side, an edge region adjacent to the top side, a multiple shield conductor contact area, an active area adjacent the top side, and an upper shield contact area adjacent to the top side and external to the multiple shield conductor contact area. The method includes providing an active trench extending from the top side into the region of semiconductor material. The active trench includes a lower shield conductor, a first shield dielectric isolating the lower shield conductor from the region of semiconductor material, an upper shield conductor, and a second shield dielectric isolating the lower shield conductor from the upper shield conductor within the active area. The active trench laterally extends within the region of semiconductor material from the active area into the multiple shield conductor contact area, and the lower shield conductor and the upper shield conductor are coupled together in the multiple shield conductor contact area. The method includes providing a termination trench extending from the top side into a second portion of the region of semiconductor material. The termination trench includes the lower shield conductor, the first shield dielectric isolating the lower shield conductor from the region of semiconductor material, the upper shield conductor, and the second shield dielectric isolating the lower shield conductor from the upper shield conductor within the active area. The termination trench laterally extends within the region of semiconductor material from the active area into the multiple shield conductor contact area, and the lower shield conductor and the upper shield conductor are coupled together in the multiple shield conductor contact area. The method includes providing a shield contact in the upper shield contact area coupled to the upper shield conductor in the active trench.

In an example, a semiconductor device includes a region of semiconductor material including a top side, an edge region, a multiple shield conductor contact area, an active area, and an upper shield contact area external to the multiple shield conductor contact area. An active trench extends from the top side into the region of semiconductor material and includes a lower shield conductor, a first shield dielectric isolating the lower shield conductor from the region of semiconductor material, an upper shield conductor, and a second shield dielectric isolating the lower shield conductor from the upper shield conductor within the active area. The active trench laterally extends within the region of semiconductor material from the active area into the multiple shield conductor contact area, and the lower shield conductor and the upper shield conductor are coupled together in the multiple shield conductor contact area. A shield contact in the upper shield contact area coupled to the upper shield conductor in the active trench.

Other examples are included in the present disclosure. Such examples may be found in the figures, in the claims, or in the description of the present disclosure.

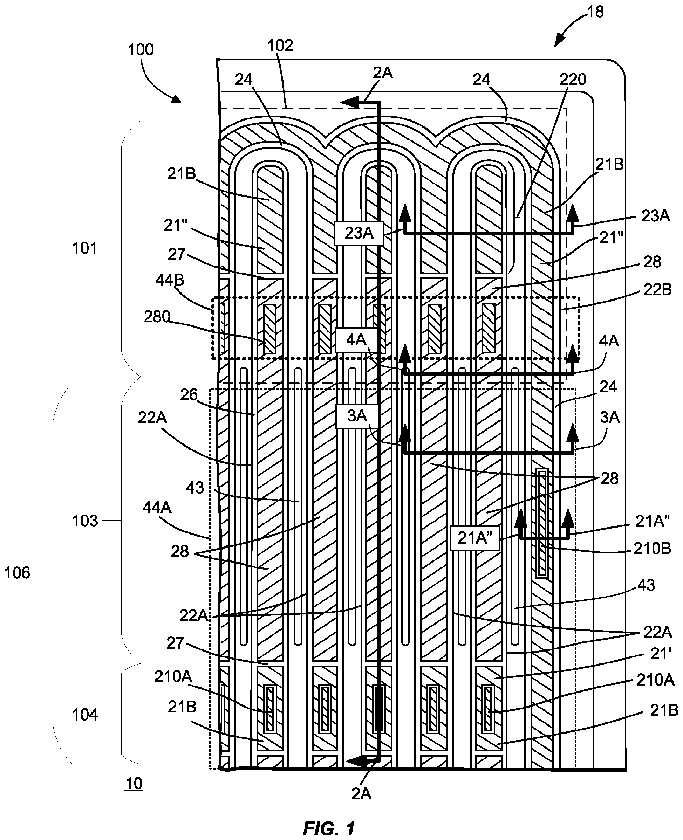

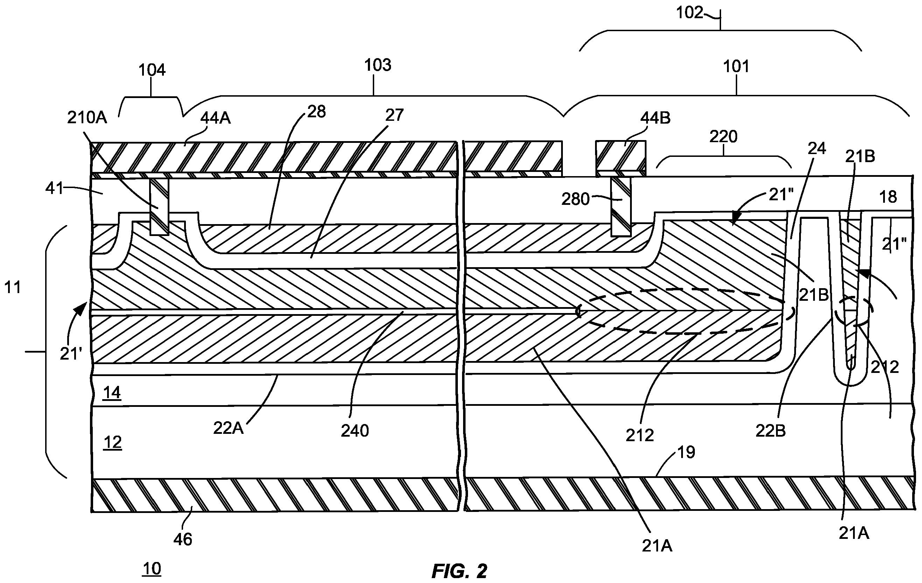

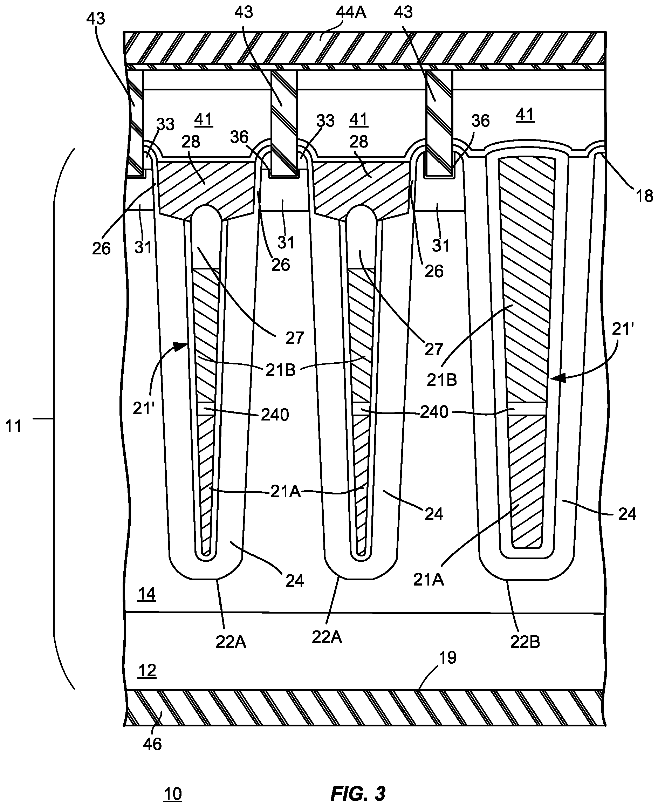

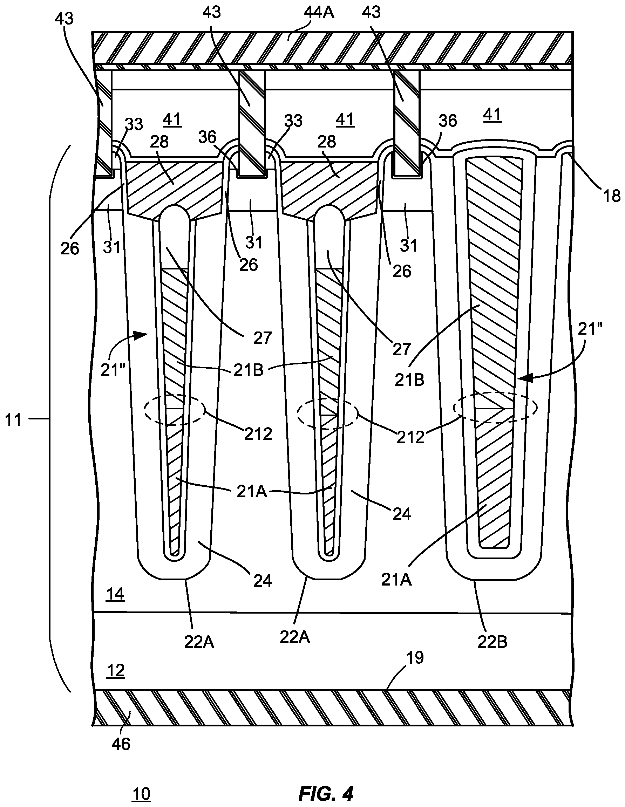

FIG. 1 illustrates a partial top plan view of a cell topography 100 of an example semiconductor device 10 in accordance with the present description. FIG. 2 illustrates a partial cross-sectional view of a portion of semiconductor device 10 taken along reference line 2A-2A of FIG. 1; FIG. 3 illustrates a partial cross-sectional view of another portion of semiconductor device 10 taken along reference line 3A-3A of FIG. 1; and FIG. 4 illustrates a partial cross-sectional view of a further potion of semiconductor device 10 taken along reference line 4A-4A of FIG. 1. Reference is made to FIGS. 1-4 in the following portion of the description.

Semiconductor device 10 is an example of a trench gate MOSFET comprising a multiple shield electrode configuration. In the present example, semiconductor device 10 comprises a dual shield electrode configuration where the shield electrodes are separated by a shield dielectric in one or more first portions of cell topography 100 and are coupled together in one or more second portions of cell topography 100. It is understood that the present description is not limited to MOSFET devices and is useful to other devices, such as insulated gate bipolar transistor (IIGBT) devices, thyristor devices, or devices where shield electrodes are utilized. Also, although the present example uses a dual-shield electrode configuration, it is understood that the present description is relevant to configurations using more than two shield conductors.

Cell topography 100 can also comprise or be referred to as a device layout or cell layout, and semiconductor device 10 can also be referred to as a semiconductor component, an electronic device structure, or an electronic component. With reference to FIG. 2, semiconductor device 10 comprises a region of semiconductor material 11 comprising a top side 18 and a lower side 19 opposite to top side 18. In the present example, cell topography 100 of semiconductor device 10 comprises a device layout or configuration that is adjacent to and extends across top side 18.

In some examples, cell topography comprises an edge region 101 adjacent to a portion top side 18, a dual shield conductor contact area 102 within edge region 101, an active area 103 adjacent to a another portion of top side 18, an upper shield contact area 104 adjacent a further portion of top side 18, and a region 106 where lower shield conductor 21A is electrically isolated from an upper shield conductor 21B by a shield dielectric 240. Region 106 can also comprise or be referred to as a dual shield isolated region where shield dielectric 240 (see for example, FIGS. 2-4) isolates or separates lower shield conductor 21A from upper shield conductor 21B. In the present example, active area 103 and upper shield contact area 104 are within region 106. In addition, upper shield contact area 104 is external to or laterally spaced apart from dual shield conductor contact area 102.

In some examples, edge region 101 can correspond to a portion of cell topography 100 where active trenches 22A each terminate with a tip region 220 and termination trench 22B wraps around tip regions 220 of active trenches 22A and feeds into additional active trenches 22A, which run in an opposing direction and terminate with tip regions 220 at an opposite edge region of cell topography 100. In some examples, edge region 101 includes gate contacts 280, which are coupled to gate electrodes 28 and conductor 44B (see for example, FIG. 2).

In some examples, cell topography 100 is suitable for medium voltage semiconductor devices 10, such as 30 volt to 100 volt shielded-gate trench MOSFET devices. However, the structures and methods described herein are also relevant to higher voltage devices. In the top plan view of FIG. 1, source conductor 44A and gate conductor 44B of semiconductor device 10 are illustrated in phantom to better illustrate the structure below but are further illustrated in the cross-sectional views of FIGS. 2, 3, and 4. It is understood that in the present example, cell topography 100 can represent an upper right portion of a device cell and that the topography illustrated can be duplicated and reoriented (e.g., flipped vertical and/or horizontal) to provide a complete cell topography for semiconductor device 10 with a desired number of active trenches 22A and termination trenches 22B.

In the present example, semiconductor device 10 comprises a body of semiconductor material 11, which can include a semiconductor substrate 12 and a semiconductor region 14 provided over or as part of semiconductor substrate 12. Semiconductor device 10 further comprises active trenches 22A and one or more termination trenches 22B. In the present example, active trenches 22A are provided as a plurality of elongated stripe active trenches each terminating with a tip region 220. In the present example, active trenches 22A illustrated in FIG. 1 with tip regions 220 can be coupled or tied together at an opposing edge of cell topography 100 with, for example, the opposite side or lower side of termination trench 22B. In the present example, one or more of active trenches 21A laterally extends with region of semiconductor material 11 from active area 103 to dual shield conductor contact area 102.

In the present example, semiconductor device 10 comprises lower shield conductor 21A; upper shield conductor 21B; a shield dielectric 24, which isolates lower shield conductor 21A and upper shield conductor 21B from semiconductor region 14; a gate electrode 28 above upper shield conductor 21B and isolated from upper shield conductor 21B by inter-electrode dielectric 27, and isolated from semiconductor region 14 by gate dielectric 26. In the present example, portions of lower shield conductor 21A are isolated from portions of upper shield conductor 21B by shield dielectric 240 to provide a dual shield configuration. It is understood that additional shield conductors or electrodes and shield dielectrics can be used to provide a multiple shield conductor configuration for semiconductor device 10.

Shield dielectric 24 can be an example of a first shield dielectric and shield dielectric 240 can be an example of a second shield dielectric. Lower shield conductor 21A can be an example of a first shield conductor or a first shield electrode, and upper shield conductor 21B can be an example of a second shield conductor or a second shield electrode. In the present example, dual shield electrode 21' can be used describe those portions of semiconductor device 10 (including active trenches 22A and termination trench 22B) where shield dielectric 240 isolates lower shield conductor 21A from upper shield conductor 21B, and shield electrode 21" can be used to describe those portions of semiconductor device 10 where lower shield electrode 21A is coupled to upper shield conductor 21B.

In accordance with the present description, one or more regions are provided within semiconductor device 10 that are devoid of shield dielectric 240 and recessed contact regions 212 are provided between lower shield conductor 21A and upper shield conductor 21B (see for example, FIGS. 2 and 4). More particularly, recessed contact regions 212 are inside active trenches 22A and termination trench 22B below top side 18 and where lower shield conductor 21A contacts or connects to upper shield electrode 22B. In the present example, a dual shield conductor contact area 102 is provided within cell topography 100 and is an example location for recessed contact regions 212. Dual shield conductor contact area 102 may comprise or be referred to as a multiple shield conductor contact area, a multiple shield conductor contact region, or a recessed shield conductor contact area, and refer to those portions of cell topography 100 where recessed contact regions 212 are located. In some examples, one or more recessed contact regions 212 laterally extend underneath gate contacts 280 as generally illustrated in FIG. 2. In the present example, dual shield conductor contact area 102 is provided devoid of any shield contacts 210A.

In some examples, shield contact 210A is provided in upper shield contact area 104 of cell topography 100 and is coupled to upper shield conductor 21B in a region of semiconductor device 10 where shield dielectric 240 isolates upper shield conductor 21B from lower shield electrode 21A (see for example, FIGS. 2 and 3). In this way, upper shield conductor 21B provides a lateral conduction path from upper shield contact area 104 to dual shield conductor contact area 102 of where recessed contact regions 212 are provided between lower shield conductor 21A and upper shield conductor 21B. In accordance with the present description, the interconnect scheme or layout between lower shield conductor 21A and upper shield conductor 21B is an advantage because it avoids having to use a separate shield contact structure for lower shield conductor 21A. In the present interconnect scheme, shield contacts 210A provide direct contact to upper shield conductor 21B and indirect contact to lower shield conductor 21A. Among other things, this saves space and avoids an increase in die size.

In the present example, termination trench 22B also includes both lower shield conductor 21A and upper shield conductor 21B. Similar to active trenches 22A, part of termination trench 22B includes shield dielectric 240 isolating lower shield conductor 21A from upper shield conductor 21B, which is illustrated, for example, in FIGS. 2 and 3. In the present example, one of recessed contact regions 212 couples lower shield conductor 21A and upper shield conductor 21B together in dual shield conductor contact area 102 of cell topography 100, which is further illustrated in FIGS. 2 and 4.

With reference to FIGS. 3 and 4, semiconductor device 10 comprises region of semiconductor material 11, which may also comprise or be referred to as a body of semiconductor material, a semiconductor work piece, a semiconductor region, or a semiconductor material. In some examples, region of semiconductor material 11 comprises silicon. In other examples, region of semiconductor material 11 or portions thereof can comprise other semiconductor materials, including, but not limited to silicon-germanium, silicon-germanium-carbon, carbon-doped silicon, silicon carbide, gallium nitride, or other related or equivalent materials as known to one of ordinary skill in the art.

In some examples region of semiconductor material 11 can comprise substrate 12, such as an N-type silicon substrate, and semiconductor region 14 can be adjacent to substrate 12. Substrate 12 can also be referred to as a semiconductor substrate or starting substrate and semiconductor region 14 can also be referred to as a semiconductor layer(s) or an extended drain region. In some examples, substrate 12 has a resistivity ranging from about 0.0005 ohm-cm to about 0.005 ohm-cm. By way of example, substrate 12 can be doped with phosphorous, arsenic, or antimony. In the example illustrated, substrate 12 provides a drain region, drain contact, or a first current carrying contact for semiconductor device 10. Region of semiconductor material 11 comprises a top side 18 and a lower side 19 opposite to top side 18. Top side 18 can also be referred to as a an upper side or a first major surface, and lower side 19 can also be referred to as a back side or a second major surface.

In some examples, semiconductor region 14 can be formed using semiconductor epitaxial growth techniques. Alternatively, semiconductor region 14 can be formed using semiconductor doping and diffusion techniques, or other techniques as known to one of ordinary skill in the art. In an example suitable for a 50 volt device, semiconductor region 14 can comprise an N-type conductivity and a dopant concentration of about 1.0x10¹⁶ atoms/cm³ to about 5.0x10¹⁷ atoms/cm³ and can have a thickness from about 3 microns to about 5 microns. The dopant concentration and thickness of semiconductor region 14 can be increased or decreased depending on the desired drain-to-source breakdown voltage (BV_{DSS}) rating of semiconductor device 10. In some examples, semiconductor region 14 can comprise a graded dopant profile. In an alternate example, the conductivity type of substrate 12 can be opposite to the conductivity type of semiconductor region 14 to form, for example, an IGBT semiconductor device.

Shield dielectric 24 can be one or more dielectric or insulative materials. In some examples, shield dielectric 24 can comprise a thermal oxide layer with a thickness in a range from about 0.1 micron to about 1.5 microns. In some examples, shield dielectric 24 can be multiple layers of similar or different materials, such as thermal and deposited dielectric or insulative materials. The thickness of the shield dielectrics will vary with the required BV_{DSS} of the device, with higher BV_{DSS} requiring thicker layers. Shield dielectric 240 can be one or more dielectric or insulative materials. In some examples, shield dielectric 240 can be a thermal oxide layer having a thickness in a range from about a 0.05 micron to about 0.5 microns. In some examples, shield dielectric 240 can be multiple layers of similar or different materials, such as thermal and deposited dielectric or insulative materials. In some examples, shield dielectric 240 can comprise a thickness less than shield dielectric 24 and greater than gate dielectric 26. In some examples, shield dielectric 240 can comprise a thickness less than inter-electrode dielectric 27.

Gate dielectric 26 and inter-electrode dielectric 27 can comprise oxides, nitrides, tantalum pentoxide, titanium dioxide, barium strontium titanate, high k dielectric materials, combinations thereof, or other related or equivalent materials known by one of ordinary skill in the art. In some examples, gate dielectric 26 and inter-electrode dielectric 27 can be silicon oxide. In some examples, gate dielectric 26 can have a thickness from about 0.02 microns to about 0.1 microns, and inter-electrode dielectric 27 can have a thickness that is greater than that of gate dielectric 26. In some examples, inter-electrode dielectric can have a thickness from about 0.1 microns to about 0.5 microns. In some examples, dielectric 24 can have a greater thickness than gate dielectric 26 and inter-electrode dielectric 27.

In some examples, gate electrodes 28, lower shield conductors 21A, and upper shield conductors 21B comprise a doped polycrystalline semiconductor material, such as doped polysilicon. In some examples, N-type conductivity dopant materials can be used to dope the polysilicon. In some examples, metals, silicides, or other conductors can be included as part of gate electrodes 28, lower shield conductors 21A, or upper shield conductors 21B.

Semiconductor device 10 comprises a body region 31 extending inward from top side 18 into region of semiconductor material 11 (for example, extending inward into semiconductor region 14) adjacent to active trenches 22A. Body region 31 can also comprise or be referred to as a doped region or a base region. Body region 31 can have a conductivity type that is opposite to the conductivity type of semiconductor region 14. For example, when semiconductor region 14 comprises N-type conductivity, body region 31 comprises P-type conductivity. Body region 31 comprises a dopant concentration suitable for forming inversion layers that operate as channel regions for semiconductor device 10. In some examples, body region 31 can extend from top side 18 to a depth from about 0.3 microns to about 1.5 micron. Body region 31 can be formed using doping techniques, such as ion implantation and anneal techniques. In some examples, body region 31 is a single continuous and interconnected region. In other examples, body region 31 can be a plurality of regions including separated or discrete regions or cells.

Semiconductor device 10 can further comprise doped regions 33 within body region 31. In some examples, body region 31 adjoining termination trench 22B can be devoid of doped regions 33. Doped regions 33 may also be referred to as source regions, current carrying regions, or current conducting regions. Doped regions 33 comprise an N-type conductivity when body region 31 comprises a P-type conductivity and can be formed using, for example, a phosphorous or arsenic dopant source. In some examples, an ion implant doping process can be used to form doped regions 33 within body region 31. Doped regions 33 can extend from top side 18 to a depth for example, from about 0.2 microns to about 0.5 microns. Doped regions 33 can be an example of second current carrying regions.

In some examples, semiconductor device 10 further comprises interlayer dielectric (ILD) 41 above gate electrode 28. In some examples, interlayer dielectric 41comprises silicon oxides, such as doped or undoped deposited silicon oxides. In some examples, interlayer dielectric 41 can include one layer of deposited silicon oxide doped with phosphorous or boron and phosphorous and one layer of undoped oxide. In some examples, interlayer dielectric 41 can have a thickness from about 0.25 microns to about 1.0 microns. In some examples, interlayer dielectric 41 can be planarized to provide a more uniform surface topography, which improves manufacturability.

In some examples, semiconductor device 10 further comprises body contact regions 36 within body region 31. Body contact regions 36 also can be referred to as doped regions, enhancement regions, or contact regions. In some examples, body contact region 36 can comprise P-type conductivity and are configured to provide a lower contact resistance to body region 31. Ion implantation (for example, using boron) and anneal techniques can be used to form body contact regions 36.

In some examples, semiconductor device 10 further comprises conductive regions 43, which are configured to provide electrical contact to doped regions 33 and body region 31 through body contact regions 36. In some examples, conductive regions 43 comprise conductive plugs or plug structures. In some examples, conductive regions 43 can include a conductive barrier structure or liner and a conductive fill material. In some examples, the barrier structure can include a metal/metal-nitride configuration, such as titanium/titanium-nitride or other related or equivalent materials as known by one of ordinary skill in the art. In other examples, the barrier structure can further include a metal-silicide structure. In some examples, the conductive fill material includes tungsten. In some examples, conductive regions 43 can be planarized to provide a more uniform surface topography.

In some examples, conductors 44A and 44B can be formed adjacent to top side 18, and conductor 46 can be formed adjacent to lower side 19. Conductors 44A and 44B can also be referred to as a top metal or a top conductor, and conductor 46 can also be referred to as a bottom conductor or a back metal. Conductors 44A, 44B, and 46 can be configured to provide electrical connection between the individual cells of semiconductor device 10 and a next level of assembly. In some examples, conductors 44A and 44B comprise titanium/titanium-nitride/aluminum-copper or other related or equivalent materials known by one of ordinary skill in the art and is configured as a source electrode or terminal. In some examples, conductor 46 comprises a solderable metal structure such as titanium-nickel-silver, chromium-nickel-gold, or other related or equivalent materials known by one of ordinary skill in the art and is configured as a drain electrode or terminal. In some examples, a further passivation layer (not shown) can be formed adjacent to conductors 44A and 44B. In some examples, shield electrode 21' and shield electrode 21" can be connected to conductor 44A so that shield electrode 21' and shield electrode 21" are configured to be at the same potential as doped regions 33 when semiconductor device 10 is in use. In other examples, shield electrode 21' and shield electrode 21" can be configured to be independently biased or can be electrically floating.

In an example, the operation of semiconductor device 10 can proceed as follows. If conductor 44A and shield electrodes 21' and 21" are operating at a potential V_{S} of zero volts, gate electrodes 28 would receive a control voltage V_{G} of 10 volts, which is greater than the conduction threshold of semiconductor device 10 and drain electrode (or output terminal) 46 would operate at a drain potential V_{D} of less than 2.0 volts. The values of V_{G} and V_{S} would cause body region 31 to invert adjacent gate electrodes 28 to form channel regions, which would electrically connect doped regions 33 to semiconductor region 14 in active trenches 22A. A device current I_{DS} would flow from conductor 46 and would be routed through semiconductor region 14, the channel regions, and doped regions 33 to conductor 44B. In some examples, I_{DS} is on the order of 10.0 amperes. To switch semiconductor device 10 to the off state, a control voltage V_{G} that is less than the conduction threshold of semiconductor is applied. Such a control voltage would remove the channel regions and I_{DS} would no longer flow through semiconductor device 10. In accordance with the present description the configuration of semiconductor device 10 as described herein uses a multiple shield electrode configuration with localized coupling (that is, coupling is facilitated using dual shield conductor contact area 102) between shield conductors to achieve improved BV_{DSS} performance through charge balance techniques and reduces gate-to-drain capacitance C_{gd} and Qrr thereby improving, among other things, switching performance.

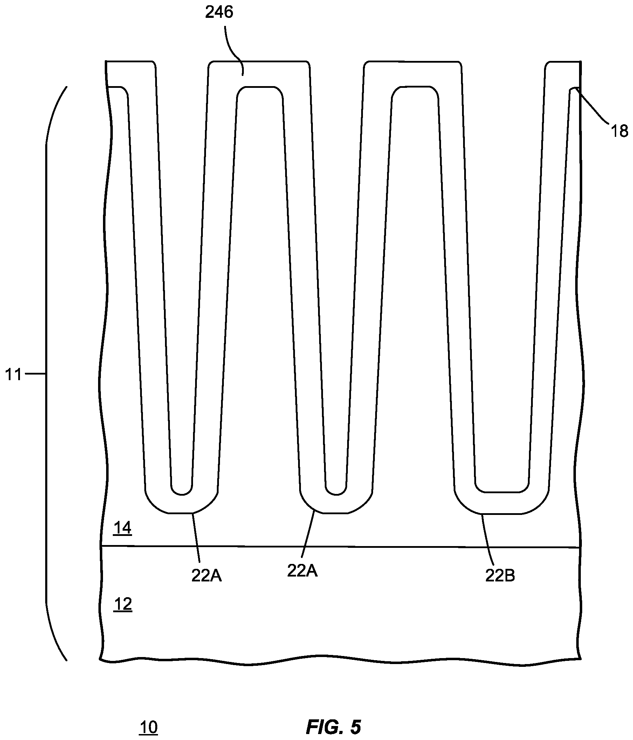

FIGS. 5-20 illustrate partial cross-sectional views of a semiconductor device at various stages of fabrication in accordance with the present description. The method described in FIGS. 5-20 can be used to fabricate, form, or make, for example, semiconductor device 10 as described in FIGS. 1-4. Among other things, the methods described herein illustrate steps to provide regions of semiconductor device 10 comprising shield dielectric 240 isolating lower shield conductor 21A from upper shield conductor 21B and regions of semiconductor device 10 where lower shield conductor 21A is coupled including electrically coupled to upper shield conductor 21B through one of recessed contact regions 212. Although the respective regions described above may be illustrated in some of the following cross-sectional views in a side-by-side configuration, it is understood that this is to simplify the description and that the respective regions may be laterally separated or provided in certain parts of semiconductor device 10 as illustrated in FIG. 1. However, in other examples the respective regions can be in a side-by-side configuration as illustrated.

FIG. 5 illustrates semiconductor device 10 at an early step in fabrication. In the present example, region of semiconductor material 11 can be provided comprising substrate 12 and semiconductor region 14 as described previously. In some examples, a masking and etching process can be used form active trenches 22A and termination trench 22B extending from top side 18 of body of semiconductor material 11 into and terminating within semiconductor region 14. When region of semiconductor material 11 comprises silicon, active trenches 22A and termination trench 22B can be provided using a fluorine etch chemistry or a similar chemistry as known to one of ordinary skill in the art. In some examples, active trenches 22A can have a width in range from about 500 nanometers to about 700 nanometers, and termination trench 22B can have similar or different width than active trenches 22A. In some examples, active trenches 22A are provided as elongated stripe trenches comprising tip regions 220 as illustrated in FIGS. 1 and 2. In some examples, active trenches 22A and termination trench 22B can comprise sloped sidewall surfaces and a rounded lower surface. In a next step, a dielectric 246 is provided over top side 18 and over surfaces of active trenches 22A and termination trench 22B. In some examples, dielectric 246 comprises a thermal oxide with a thickness from about 0.1 micron to about 1.5 microns.

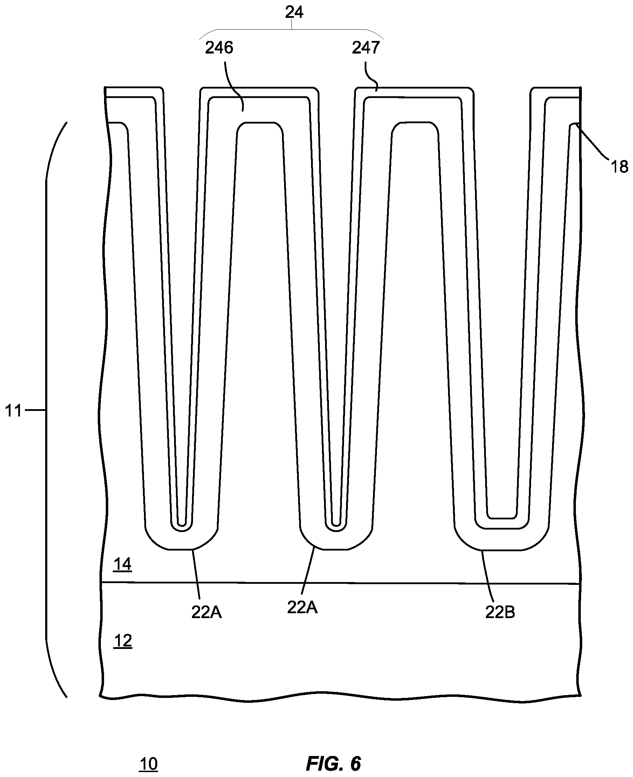

FIG. 6 illustrates semiconductor device 10 after further processing. In the present example, dielectric 247 can be provided over dielectric 246. In some examples, dielectric 247 can comprise a deposited oxide formed using chemical vapor deposition (CVD) techniques. In some examples, dielectric 247 can have thickness from about 0.05 microns to about 0.3 microns. In the present example, dielectric 246 and dielectric 247 form shield dielectric 24 of semiconductor device 10.

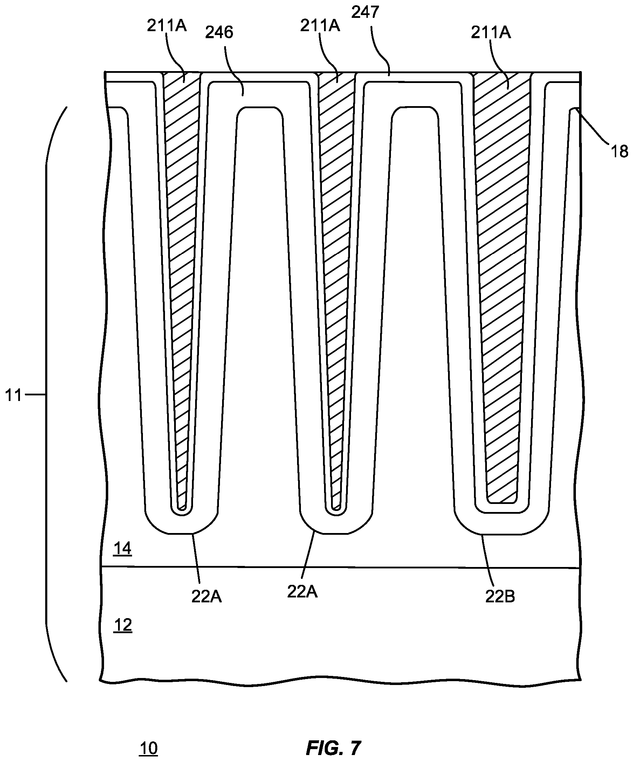

FIG. 7 illustrates semiconductor device 10 after further processing. In the present example, conductive material 211A is provided within active trenches 22A and termination trench 22B. Conductive material 211A can comprise or be referred to as a shield conductor or a shield conductive material. In some examples, conductive material 211A comprises a polycrystalline semiconductor material, such as doped polysilicon. In some examples, conductive material 211A comprises polysilicon doped with an N-type dopant and can be provided using CVD techniques. In some examples, a planarization process can be used to planarize and remove portions of conductive material 211A over top side 18 leaving other portions of conductive material 211A within active trenches 22A and termination trench 22B. In some examples, chemical mechanical planarization (CMP) techniques can be used to planarize conductive material 211A. In some examples, the planarization process leaves the top side of conductive material 211A substantially coplanar with the top side of dielectric 247. Conductive material 211A can be an example of a first conductive material.

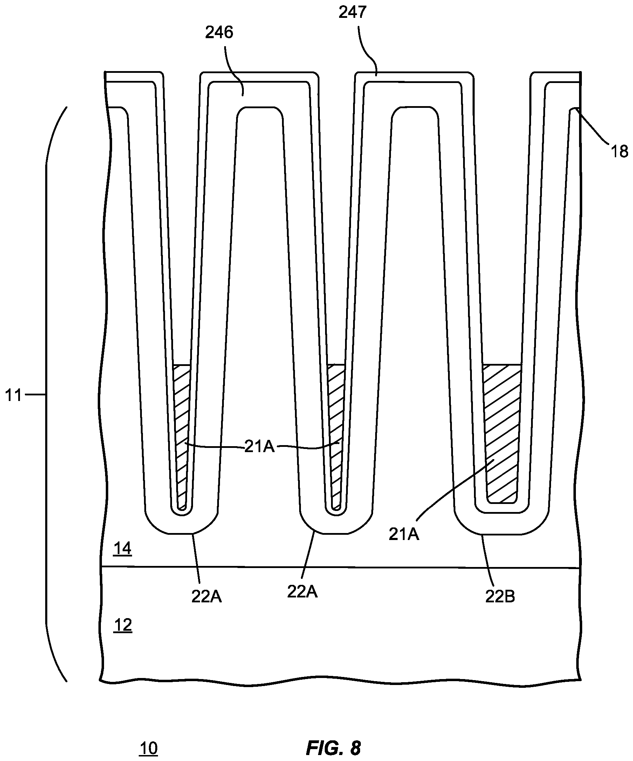

FIG. 8 illustrates semiconductor device 10 after further processing. In the present example, portions of conductive material 211A are removed from within the upper parts of active trenches 22A and termination trench 22B to form lower shield conductor 21A. In some examples, when conductive material 211A comprises polysilicon, dry etching techniques with a fluorine chemistry can be used to form lower shield conductors 21A In some examples, lower shield conductors 21A can have thickness or height in a range from about 0.3 microns to about 2.0 microns.

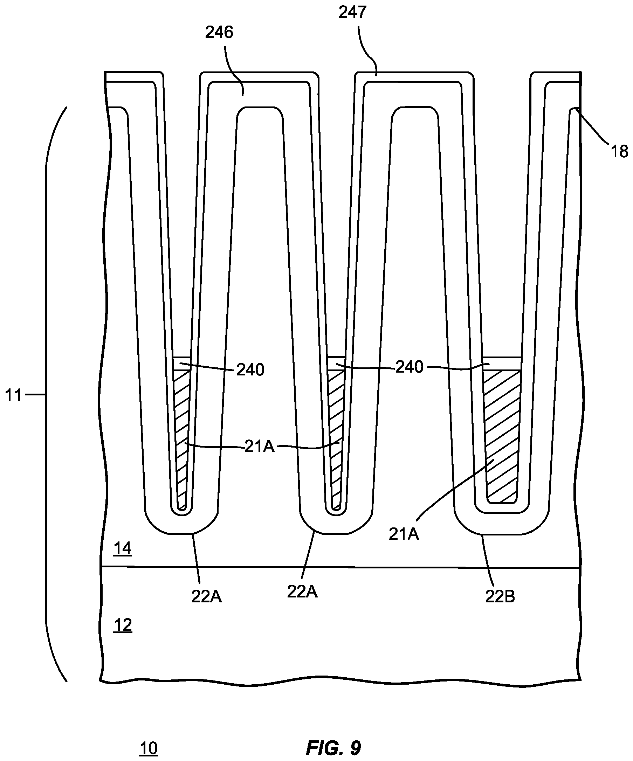

Next, shield dielectric 240 can be provided over lower shield conductors 21A as illustrated in FIG. 9. In some examples, shield dielectric 240 comprises thermal oxide. In some examples, shield dielectric 240 can have a thickness from about 0.03 microns to about 0.15 microns.

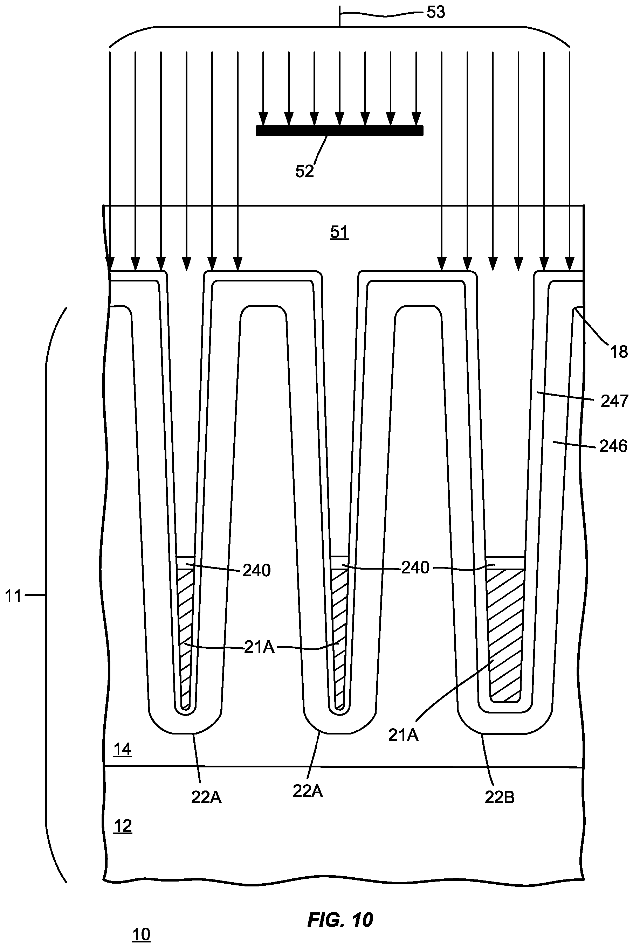

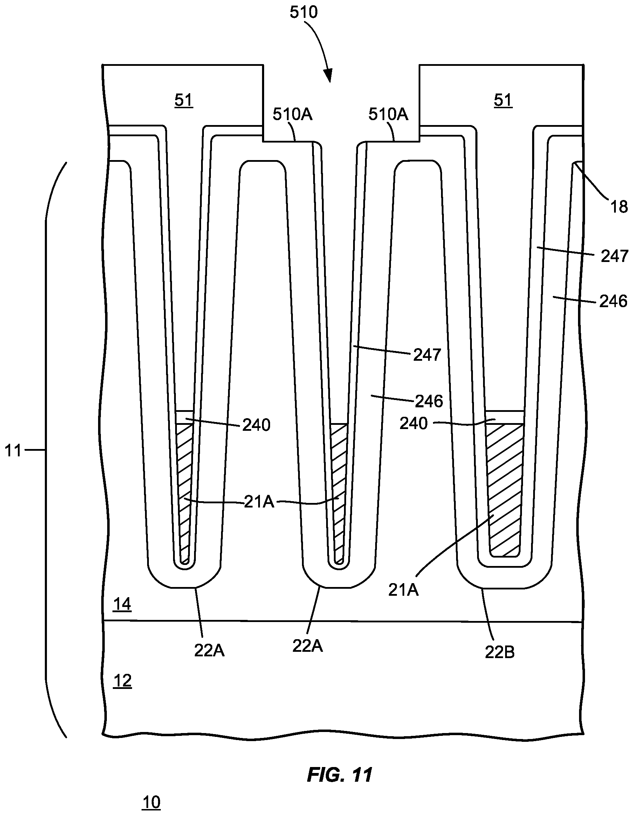

FIG. 10 and FIG. 11 illustrate semiconductor device 10 after further processing. More particularly, FIG. 10 and FIG. 11 illustrate process steps for forming recessed contact regions 212 in selected region(s) of semiconductor device 10 while leaving shield dielectric 240 in other region(s) of semiconductor device 10. In the present example, photoresist layer 51 is provided over region of semiconductor material 11 including within active trenches 22A and termination trench 22B. It was found through experimentation that it is preferred in some examples that photoresist layer 51 comprise a negative photoresist layer as opposed to positive photoresist when removing shield dielectric 240 from certain regions of semiconductor device 10. It was found that with positive photoresist, an over-exposure of the positive photoresist was required to clear the positive photoresist from within active trenches 22A and termination 22B where shield dielectric 240 is to be removed. In some cases, complete removal of the positive after exposure was difficult and inconsistent, which would result in reduced manufacturing yields and cycle times. With positive photoresist, exposure to UV light is necessary to change the chemical structure of the resist so that it becomes more soluble in a photoresist developer. With negative photoresist, exposure to UV light causes the chemical structure of the photoresist to polymerize, which is opposite to positive resist. Instead of becoming more soluble in a photoresist developer, the exposed negative photoresist becomes difficult to dissolve. Thus, with photoresist layer 51 comprising a negative photoresist, overexposure is not needed deep within the trenches but instead, exposure is only needed to reach those portions of top side 18 that adjoin active trenches 22A and termination trench 22B.

As illustrated in FIG. 10, a mask 52 is provided over a region of semiconductor device 10 where one or more of recessed contact regions 212 is to be provided, and photoresist layer 51 is exposed to a UV light source 53. In the present example, this polymerizes photoresist layer 51 over the left one of active trenches 22A and over termination trench 22B. After exposure to UV light source 53, photoresist layer 51 is developed, which removes the unexposed portion of photoresist layer 51 above and within a first portion of the right one of active trenches 22A forming opening 510 as illustrated in FIG. 11. For example, the first portion can be within tip region 220 with active trenches 22A configured as elongated active trenches. It is understood that an exposed portion of photoresist layer 51 can remain over or covers a second portion of the right of active trenches 22A (which can be represented, for example, by the left one of the active trenches in FIGS. 10) in active area 103 of cell topography 100. In accordance with the present description, by providing photoresist layer 51 comprising a negative photoresist, manufacturing yields and cycle times are improved.

After photoresist layer 51 is removed to provide opening 510, shield dielectric 240 can be removed from active trench 22A exposed through opening 510 using wet or dry dielectric etch processes. In some examples, the removal of shield dielectric 240 also can remove exposed portions of dielectric 247 and portions of dielectric 246, which can leave recessed edge portions 510A adjoining active trench 22A exposed through opening 510. After shield dielectric 240 is removed, photoresist layer 51 can be removed using conventional processing techniques.

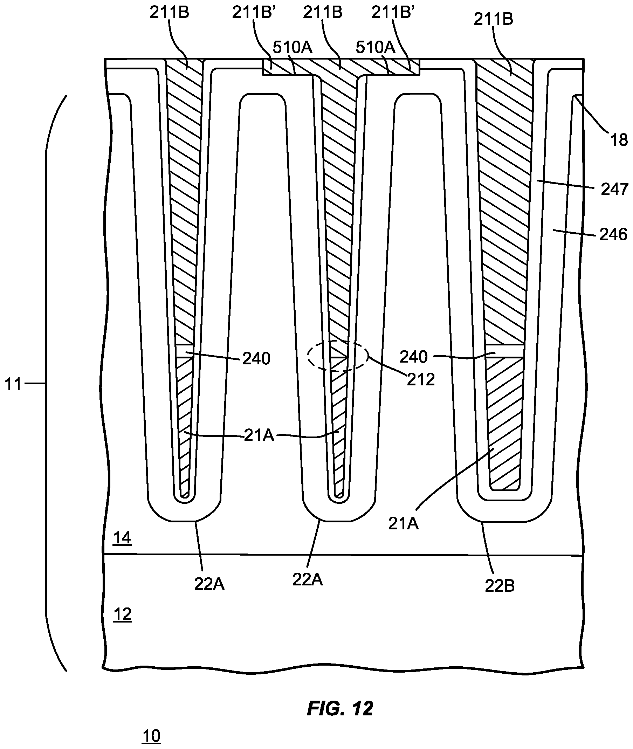

FIG. 12 illustrates semiconductor device 10 after further processing. In the present example, conductive material 211B is provided within active trenches 22A and termination trench 23 above lower shield conductor 21A. Conductive material 211B can comprise or be referred to as a shield conductor or a shield conductive material. In some examples, conductive material 211B comprises a polycrystalline semiconductor material, such as doped polysilicon. In some examples, conductive material 211B comprises polysilicon doped with an N-type dopant and can be provided using CVD techniques. In some examples, a planarization process can be used to planarize and remove portions of conductive material 211B over top side 18 leaving other portions of conductive material 211B within active trenches 22A and termination trench 22B. In some examples, portions 211B' of conductive material 211B can remain over recessed edge portions 510A after the planarization process. In some examples, CMP techniques can be used to planarize conductive material 211B. In some examples, the planarization process leaves the top side of conductive material 211B substantially coplanar with the top side of dielectric 247. With the previous removal of shield dielectric 240 in the right one of active trenches 22A, lower shield conductor 21A is coupled including electrically coupled to upper shield conductor 21B through one of recessed contact regions 212. Shield dielectric 240 electrically isolates lower shield conductor 21A from upper shield conductor 21B in the left one of active trenches 22A and termination trench 22B. Conductive material 211B is an example of a second conductive material.

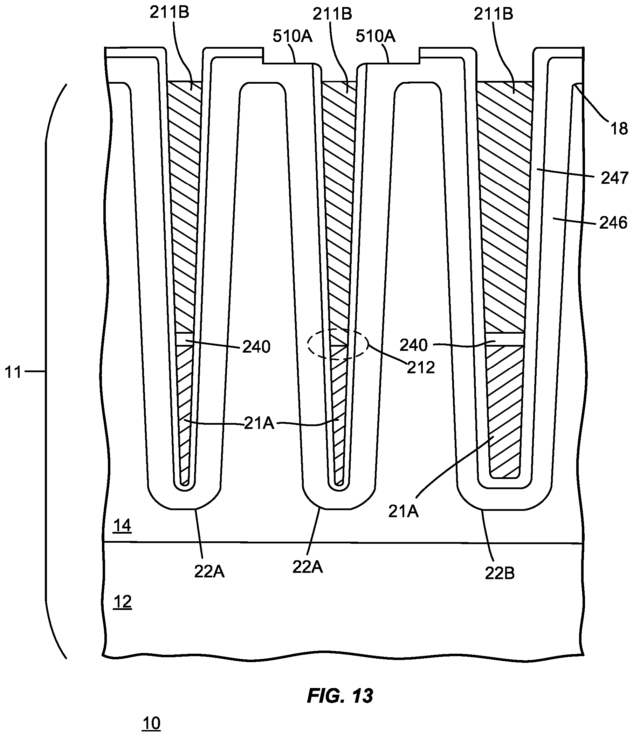

FIG. 13 illustrates semiconductor device 10 after further processing. In the present example, portions of conductive material 211B including portions 211B' are removed from within the upper parts of active trenches 22A and termination trench 22B in a first recess step that is part of a two-step removal process in accordance with the present description. The first step can comprise or be referred to a blanket removal step, a global removal step, or an unmasked removal step. In some examples, the first recess step provides the upper sides of conductive material 211B below the upper side of dielectric 247 and proximate to top side 18 in both active trenches 22A and in termination trench 21B. In some examples, when conductive material 211B comprises polysilicon, dry etching techniques with a fluorine chemistry can be used for the first recess step. In the present example, the first recess step provides upper shield conductor 21B in termination trench 22B.

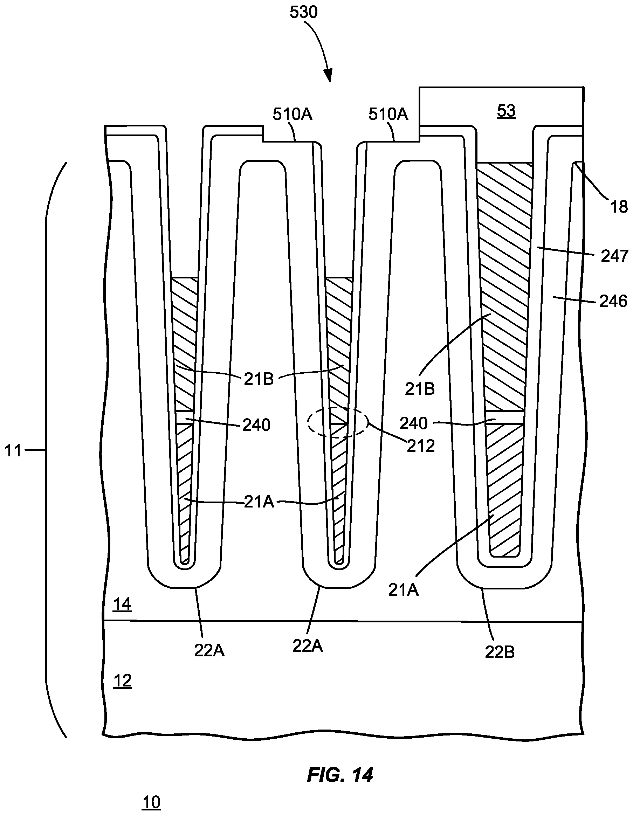

FIG. 14 illustrates semiconductor device 10 after further processing. In the present example, a masking layer 53 is provided over top side 18 and patterned to provide an opening 530, which exposes active trenches 22A. A portion of masking layer 53 remains over termination trench 22B. Other portions of masking layer 53 also remain over tip regions 220 of active trenches 22A (for example, in edge region 101 of cell topography 100) and where shield contacts 210A are provided (for example, in upper shield contact area 104 of cell topography 100). In some examples, masking layer 53 can comprise a photoresist material. Next, additional portions of conductive material 211B are removed in a second recess step to provide upper shield conductor 21B in active trenches 22A. After the second recess step, masking layer 53 can be removed. In the present example, upper shield conductors 21B in active trenches 22A are recessed below top side 18 a greater distance compared to upper shield conductor 21B in termination trench 22B. In some examples, upper shield conductors 21B in active trenches 22A can have thickness in a range from about 0.5 microns to about 3.0 microns.

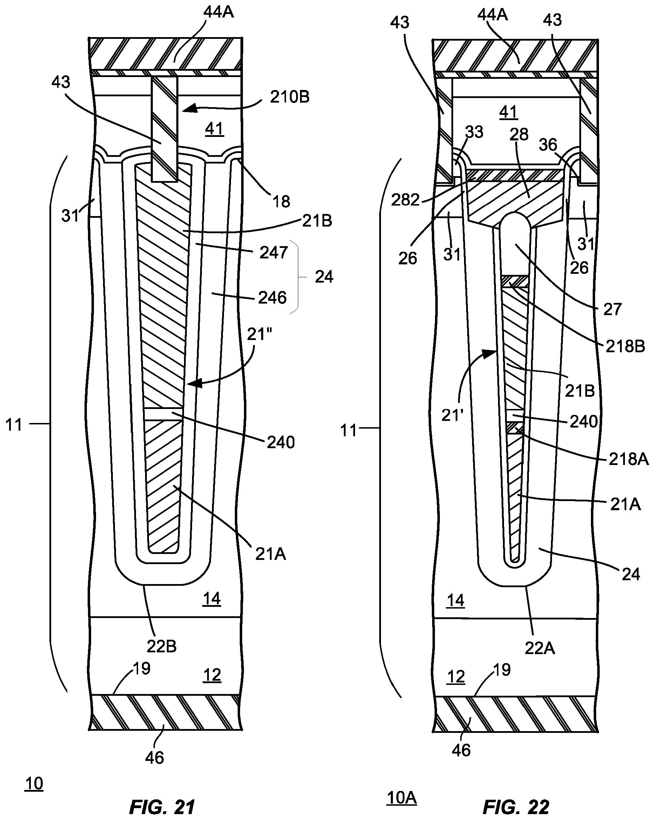

The method illustrated in FIGS. 13 and 14 is an example process improvement where a first recess is provided in a two-step process. It was found through experimentation that without the first recess step described in FIG. 13, an undercutting effect of upper shield conductor 21B in termination trench 22B occurred. This undercutting effect resulted in a mis-shaped upper topography of upper shield conductor 21B and increased the occurrence of open or floating contacts to shield contact 210B in termination trench 22B shown in FIG. 1 and FIG. 21. The two-step recess process as described herein improves the quality of the upper topography and reduces the open and floating contact issue associated with the single step recess process.

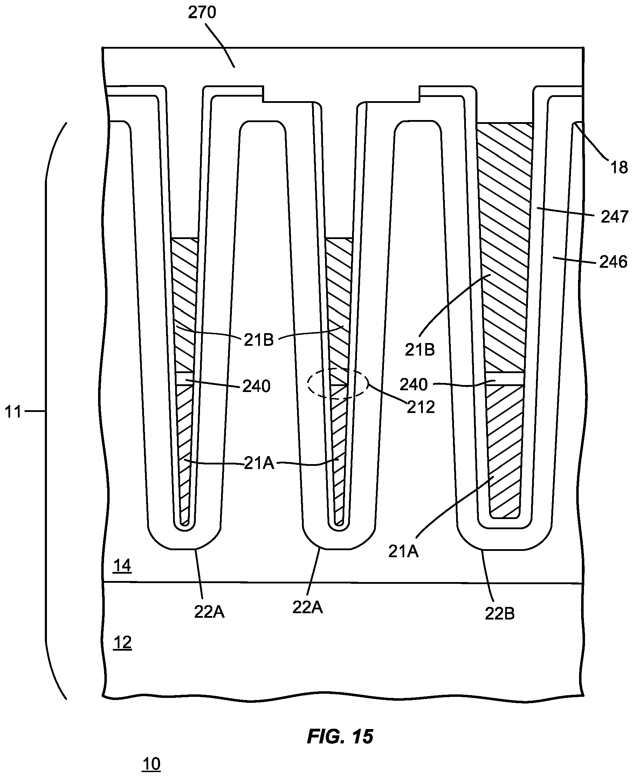

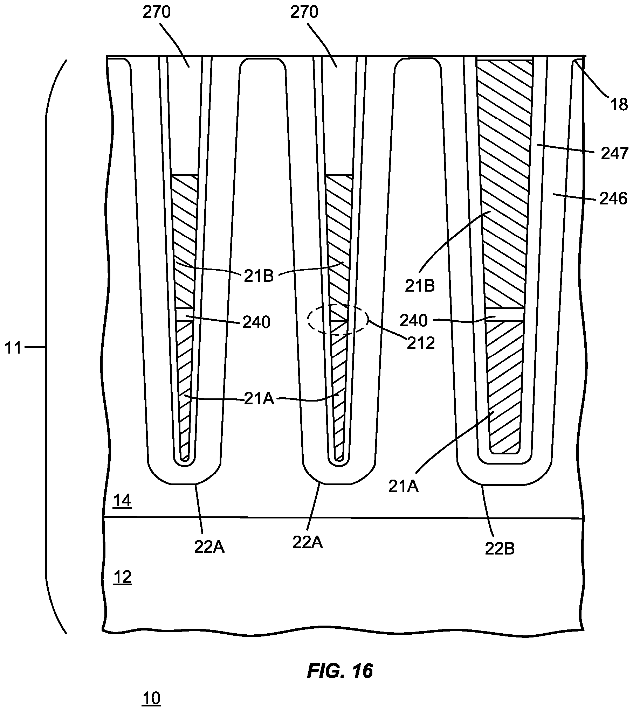

FIG. 15 illustrates semiconductor device 10 after further processing. In the present example, dielectric 270 is provided over top side 18 including the upper sides of shield conductors 21B. In some examples, dielectric 270 can comprise a borosilicate glass (BSG) dielectric or a thermal oxide. In a subsequent step, a planarization process can be used to remove portions of dielectric 270, dielectric 247, and dielectric 246 as illustrated in FIG. 16. In some examples, CMP can be used to provide an upper side of dielectric 270 substantially coplanar with top side 18 of region of semiconductor material 11.

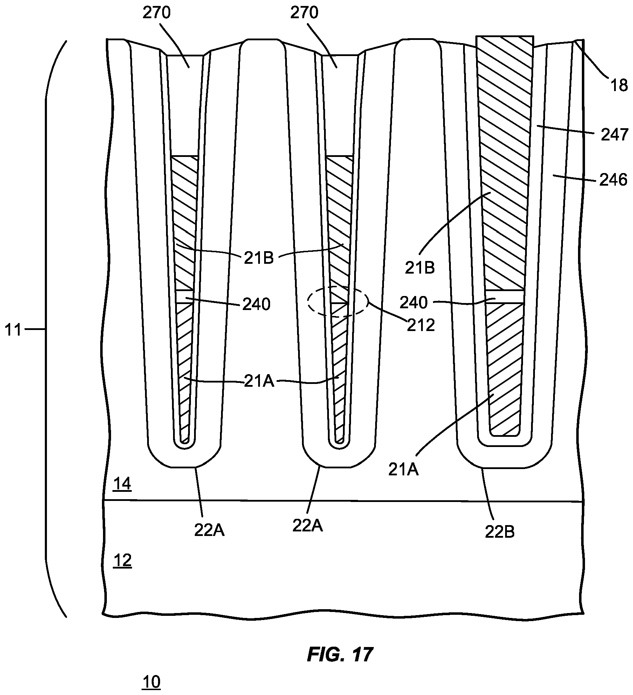

FIG. 17 illustrates semiconductor device 10 after further processing. In the present example, an etching process using hydrofluoric (HF) acid can be used to remove portions of dielectric 247 and dielectric 246 over top side 18. In some examples, this step can recess dielectric 246 and dielectric 247 below top side 18 with dielectric 247 etching at a faster rate than dielectric 246 when dielectric 247 comprises a deposited oxide and dielectric 246 comprises a thermal oxide.

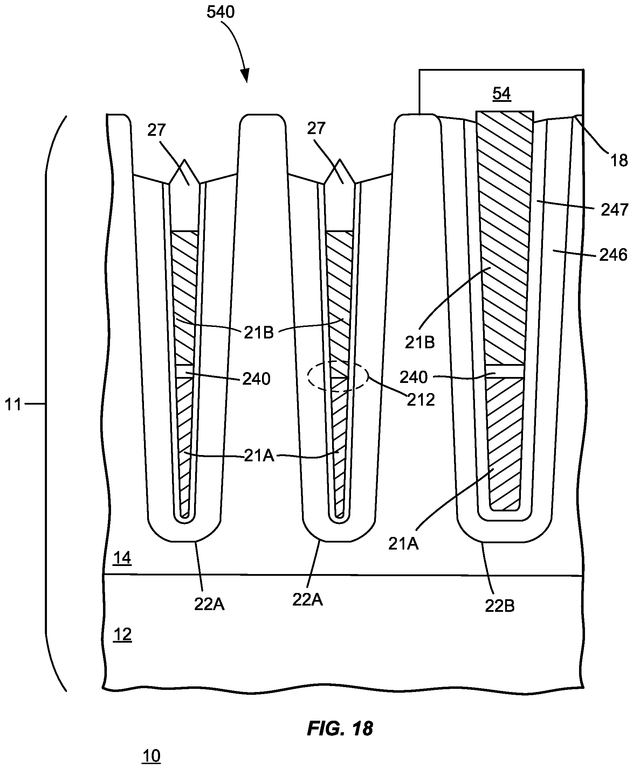

FIG. 18 illustrates semiconductor device 10 after further processing. In the present example, a masking layer 54 is provided over top side 18 and patterned to provide an opening 540, which exposes active trenches 22A. Masking layer 54 remains over termination trench 22B. In some examples, masking layer 54 comprises a photoresist layer. In some examples, after opening 540 is formed, a buffered oxide etch (BOE) can be used to further remove portions of dielectric 270, dielectric 247, and dielectric 246. In the present example, this forms inter-layer dielectric 27 above upper shield conductors 21B and exposes upper sidewalls of active trenches 22A.

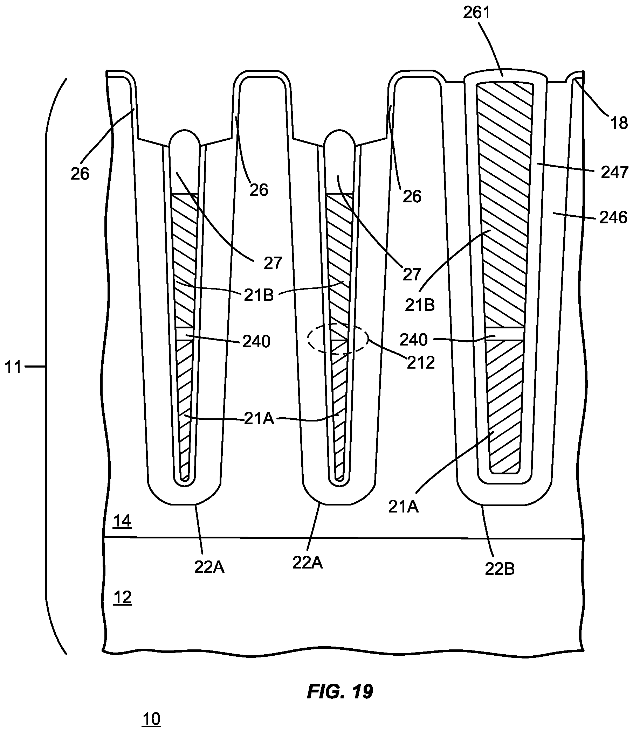

In a subsequent step, masking layer 54 can be removed and gate dielectric 26 can be provided over the exposed upper sidewalls of active trenches 22A as illustrated in FIG. 19. Gate dielectric 26 and inter-layer dielectric 27 can comprise oxides, nitrides, tantalum pentoxide, titanium dioxide, barium strontium titanate, high k dielectric materials, combinations thereof, or other related or equivalent materials known by one of ordinary skill in the art. In some examples, gate dielectric 26 can be silicon oxide formed using thermal oxidation techniques. In some examples, gate dielectric 26 can have a thickness from about 0.02 microns to about 0.1 microns. In some examples, dielectric 261 can be provided over shield conductor 21B in termination trench 22B when gate dielectric 26 is formed. Based on the polycrystalline structure of upper shield conductor 21B, dielectric 261 can have a greater thickness gate dielectric 26.

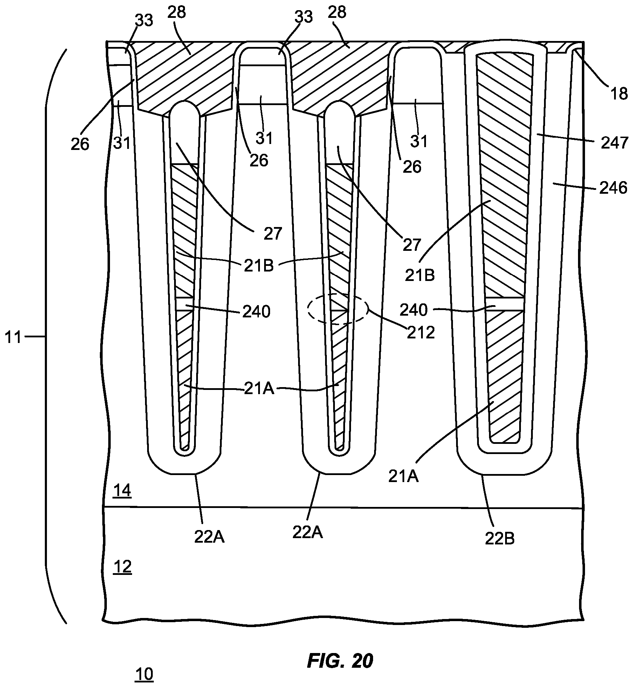

FIG. 20 illustrates semiconductor device 10 after further processing. In the present example, a gate conductor can be provided over top side 18 and planarized to provide gate electrodes 28 in active trenches 22A. In some examples, gate electrodes 28 comprise a doped polycrystalline semiconductor material, such as doped polysilicon, and can be formed using CVD processing techniques. In some examples, CMP can be used to planarize the deposited material to provide gate electrodes 28. Semiconductor device 10 can be further processed to provide body region 31, doped regions 33, body contact regions 36, ILD 41, conductive regions 43 and conductors 44a, 44B, and 46 as described previously. In accordance with the present description, the method of FIGS. 5-20 provides semiconductor device 10 comprising regions that include shield dielectric 240 isolating lower shield conductor 21A from upper shield conductor 21B and regions where lower shield conductor 21A is coupled to upper shield conductor 21B through one or more of recessed contact regions 212.

FIG. 21 illustrates a partial cross-sectional view of termination trench 22B of semiconductor device 10 taken along reference line 21A"-21A" of FIG. 1. In present example, shield contact 210B is provided in a peripheral region of cell topography 100 and makes contact to upper shield conductor 21B at a location on semiconductor device 10 where shield dielectric 240 isolates upper shield conductor 21B from lower shield conductor 21A. In this way, upper shield conductor 21A provides a lateral conduction pathway to dual shield conductor contact area 102 where one of recessed contact regions 212 couples upper shield conductor 21B and lower shield conductor 21A in termination trench 22B. Shield contact 210B is an example of a second shield contact.

FIG. 22 illustrates a partial cross-sectional view of an example semiconductor device 10A in accordance with the present description. Semiconductor device 10A of FIG. 22 has some similarity in construction to semiconductor device 10, and such similarity will not be repeated here. In the present example, semiconductor device 10A comprises shield silicide 218B over upper shield conductor 21B, which can be used to reduce shield resistance. In some examples, semiconductor device 10A can further comprise a shield silicide 218A over lower shield conductor 21A to further reduce shield resistance. In examples, where shield silicide 218A is included, shield dielectric 240 can comprise a deposited oxide. Shield silicide 218A and shield silicide 218B can comprise cobalt silicide or other materials as known to one of ordinary skill in the art. In some examples, semiconductor device 10A comprises a gate silicide 282 over gate electrode 28, which can be used to reduce gate resistance. In some examples, shield silicide 218A can be used where recessed contact regions 212 couple lower shield conductor 21A to upper shield conductor 21B.

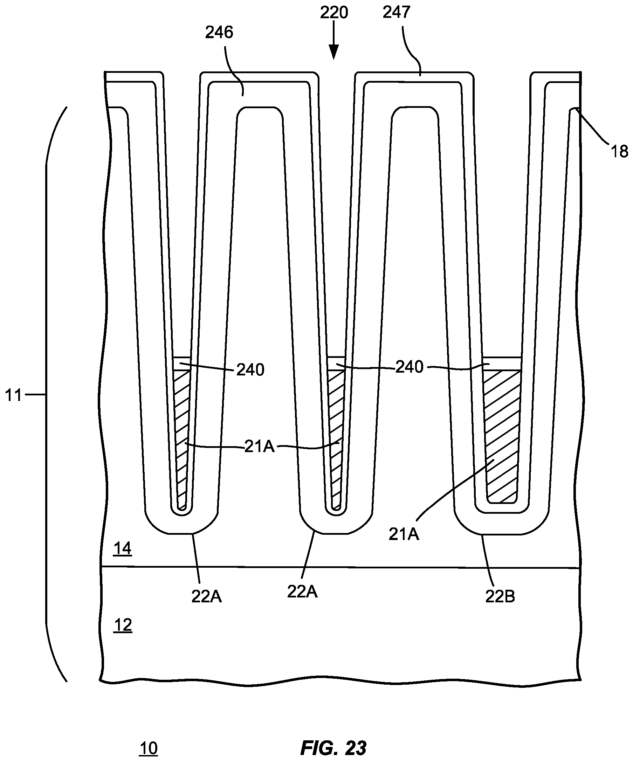

FIGS. 23-28 illustrate partial cross-sectional views of semiconductor device 10 in accordance with the present description at various stages of fabrication. More particularly, FIGS. 23-28 are an example of semiconductor device 10 taken along reference line 23A-23A of FIG. 1, which corresponds to a portion of dual shield conductor contact area 102 of cell topography 100 where recessed contact regions 212 couple lower shield conductors 21A to upper shield conductors 21B in active trenches 22A and termination trench 22B.

FIG. 23 illustrates semiconductor device 10 at a step in fabrication where lower shield conductor 21B has been provided within active trenches 22A and termination trench 22B, and shield dielectric 240 has been provided over lower shield conductor 21B. In the present example, the right one of active trenches 22A in FIG. 23 corresponds to one of tip regions 220, and the left one of active trenches 22A corresponds to active trench that extends from termination trench 22B in an opposite direction as illustrated in FIG. 1.

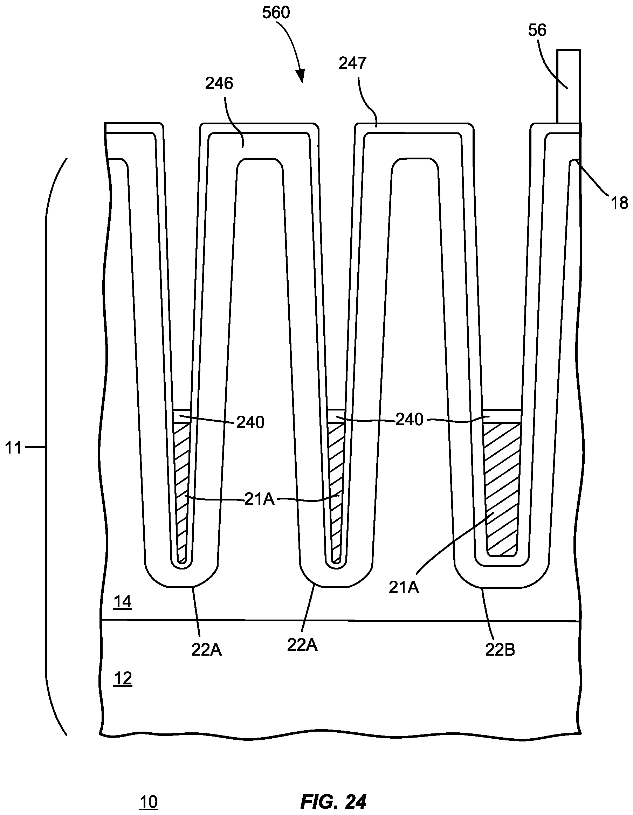

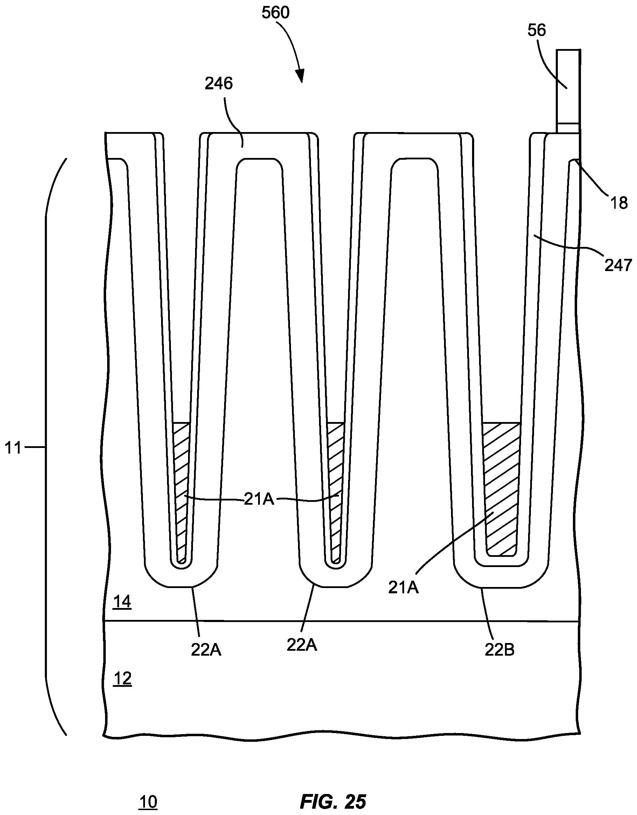

FIG. 24 illustrates semiconductor device 10 after further processing. In the present example, a masking layer 56 is provided over top side 18 and patterned to provide opening 560 that exposes active trenches 22A and termination trench 22B. In accordance with the present description, masking layer 56 preferably comprises a negative photoresist as described previously with FIGS. 10 and 11. Next, shield dielectric 240 is removed from active trenches 22A and termination trench 22B using wet or dry etch processes as illustrated in FIG. 25. In some examples, dielectric 247 can be removed at locations above top side 18 that are devoid of masking layer 56. Masking layer 56 remains in place during the etching process to protect shield dielectric 240 in those locations of semiconductor device 10 where it is desired that shield dielectric 240 isolate lower shield conductor 21A from an upper shield conductor 21B. Masking layer 56 can then be removed.

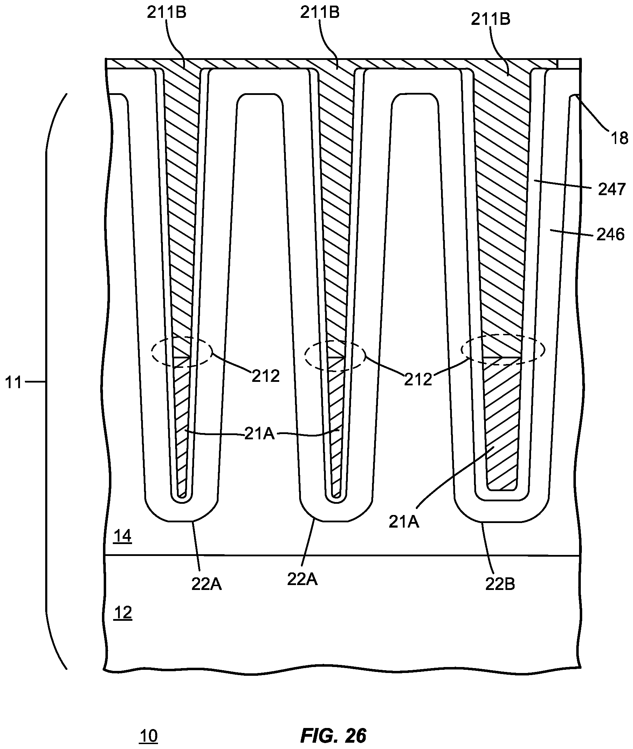

FIG. 26 illustrates semiconductor device 10 after further processing. In the present example, conductive material 211B is provided within active trenches 22A and termination trench 22B and is coupled to lower shield conductor 21A through recessed contact regions 212. Conductive material 211B can be provided as described previously with FIG. 12.

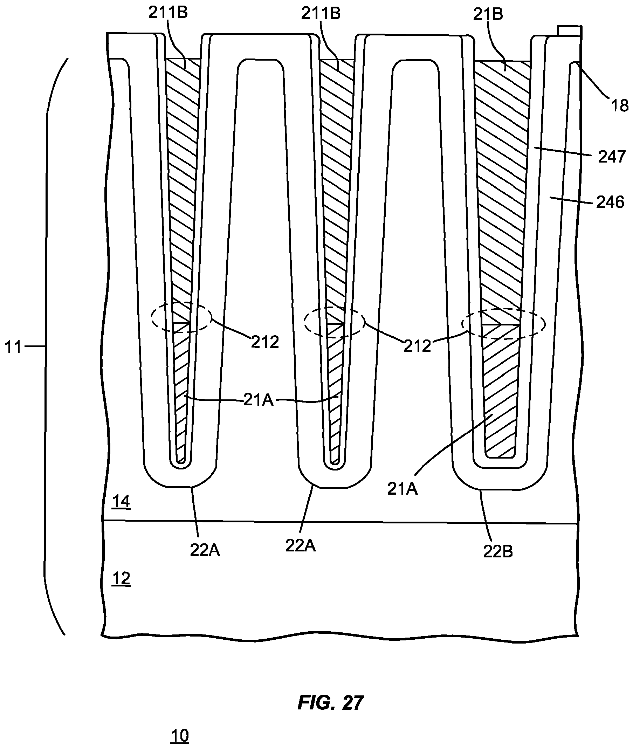

FIG. 27 illustrates semiconductor device 10 after further processing. In the present example, portions of conductive material 211B are removed from within the upper parts of active trenches 22A and termination 22B in a first recess step as described previously with FIG. 13. In the present example, the first recess step provides upper shield conductor 21B in termination trench 22B.

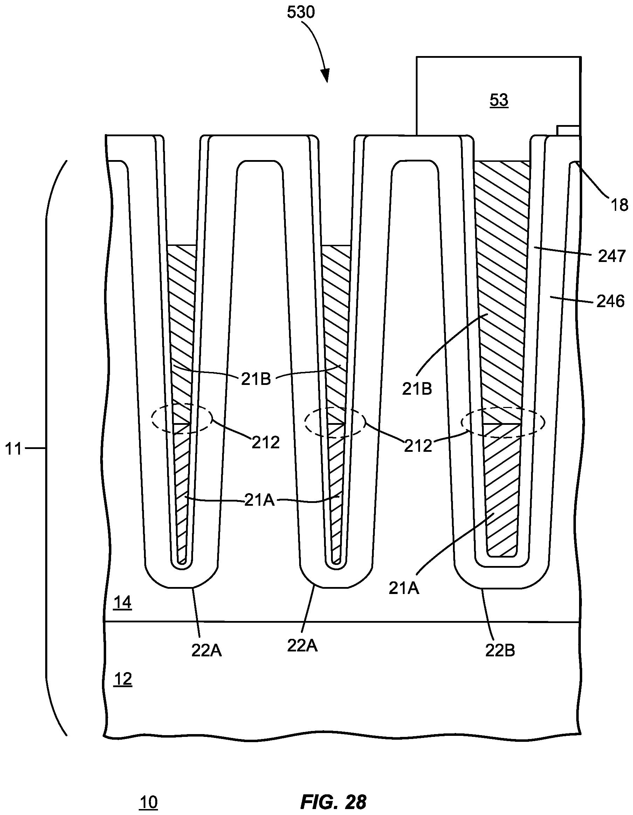

FIG. 28 illustrates semiconductor device 10 after further processing. In the present example, masking layer 53 is provided over top side 18 and patterned to provide an opening 530, which exposes active trenches 22A. A portion of masking layer 53 remains over termination trench 22B. In some examples, masking layer 53 can comprise a photoresist material. Next, additional portions of conductive material 211B are removed in a second recess step to provide upper shield conductor 21B in active trenches 22A. After the second recess step, masking layer 53 can be removed.

The method illustrated in FIGS. 27 and 28 has the same advantages as described previously with FIGS. 13 and 14 including an improved contact surface for upper shield conductor 21B in termination trench 22B. The improved contact surface reduces the likelihood of open or floating contacts to shield contact 210B in termination trench 22B as shown in FIGS. 1 and 21.

From all the foregoing, one of ordinary skill in the art can determine that in an example method, providing the masking layer can include providing the masking layer after removing the first portion of the conductive material within the active trench and the termination trench. In another example, removing the first portion of the conductive material provides the upper shield conductor in the termination trench. In a further example, the method can include providing a shield silicide over the upper shield conductor.

In summary, structures and methods have been described for a semiconductor device having improved manufacturability and performance. In some examples, structures include cell topography structures that facilitate electrical connection between multiple shield electrodes. Such structures can be provided, for example, at tip portions of active trenches. In some examples, such structure can be provided at end portions of termination trenches that wrap around the tip portions of the active trenches. In some examples, methods have been described that improve the manufacturability of electrical connection structures between multiple shield electrodes and electrical connections to the termination trenches, which improve the overall reliability of the semiconductor device. In addition, the methods and structures simplify the interconnection scheme between the shield conductors, which saves layout space, simplifies the cell topography, and reduces impact on die size.

In some examples, a negative photoresist is used in a portion of the method to provide a masking layer that protects those portions of the structure where the shield dielectric remains in place. In some examples, a two-step recess process is used to provide the upper shield conductors in both the active trenches and the termination trench.

It is understood that although present description may refer to lower shield conductor 21A as lower shield conductors 21A and refer to upper shield conductor 21B as upper shield conductors 21B, is some examples, lower shield conductor 21A or upper shield conductor 21B can be a single continuous structure.

It is understood that the different examples described herein can be combined with any of the other examples described herein to obtain different embodiments.

While the subject matter of the invention is described with specific preferred examples, the foregoing drawings and descriptions thereof depict only typical examples of the subject matter and are not therefore to be considered limiting of its scope. It is evident that many alternatives and variations will be apparent to those skilled in the art. For example, the conductivity types of the various regions can be reversed. Also, other IV-IV semiconductor materials besides SiC, such as SiGe or SiGeC can be used. Additionally, other compound semiconductor materials can be used. In addition, the structures and methods described herein can be used for higher voltage devices (for example, greater than 100 volts) or lower voltage devices (for example, less than 30 volts).

As the claims hereinafter reflect, inventive aspects may lie in less than all features of a single foregoing disclosed example. Thus, the hereinafter expressed claims are hereby expressly incorporated into this Description, with each claim standing on its own as a separate example of the invention. Furthermore, while some examples described herein include some, but not other features included in other examples, combinations of features of different examples are meant to be within the scope of the invention and meant to form different examples as would be understood by those skilled in the art.

## Claims

1. A method of manufacturing a semiconductor device, comprising:
providing a region of semiconductor material comprising:
a top side;
an edge region;
a multiple shield conductor contact area within the edge region;
an active area; and
an upper shield contact area;
providing an active trench extending from the top side into the region of semiconductor material, wherein:
the active trench comprises:
a lower shield conductor;
a first shield dielectric isolating the lower shield conductor from the region of semiconductor material;
an upper shield conductor; and
a second shield dielectric isolating the lower shield conductor from the upper shield conductor within the active area;
the active trench laterally extends within the region of semiconductor material from the active area into the multiple shield conductor contact area; and
the lower shield conductor and the upper shield conductor are coupled together in the multiple shield conductor contact area; and
providing a shield contact in the upper shield contact area coupled to the upper shield conductor in the active trench.

2. The method of claim 1, wherein:
providing the active trench comprises providing a recessed contact region between the lower shield conductor and the upper shield conductor in the multiple shield conductor contact area.

3. The method of claim 1, wherein:
providing the region of semiconductor material comprises providing the multiple shield conductor contact area devoid of any shield contacts contacting an upper surface of the upper shield conductor.

4. The method of claim 1, further comprising:
providing a termination trench extending from the top side into a second portion of the region of semiconductor material, wherein:
the termination trench comprises:
the lower shield conductor;
the first shield dielectric isolating the lower shield conductor from the region of semiconductor material;
the upper shield conductor; and
the second shield dielectric isolating the lower shield conductor from the upper shield conductor within the active area;
the termination trench laterally extends within the region of semiconductor material from the active area into the multiple shield conductor contact area; and
the lower shield conductor and the upper shield conductor are coupled together in the multiple shield conductor contact area.

5. The method of claim 4, further comprising:
providing a second shield contact external to the multiple shield conductor contact area coupled to the upper shield conductor in the termination trench.

6. The method of claim 4, wherein:
providing the active trench and the termination trench comprises:
providing the lower shield conductor within the active trench and the termination trench;
providing a conductive material within the active trench and the termination trench above the lower shield conductor;
removing a first portion of the conductive material within the active trench and the termination trench;
providing a masking layer over the conductive material in the termination trench; and
removing a second portion of the conductive material in the active trench to provide the upper shield conductor in the active trench.

7. The method of claim 1, wherein providing the active trench comprises:
providing the active trench as an elongated active trench comprising a tip portion within the multiple shield conductor contact area;
providing the first shield dielectric within the elongated active trench;
providing the lower shield conductor over the first shield dielectric;
providing the second shield dielectric over the lower shield conductor;
providing a masking layer comprising a negative photoresist and an opening,
wherein:
the opening exposes the second shield dielectric in a first portion of the elongated active trench in the multiple shield conductor contact area; and
the masking layer covers a second portion of the elongated active trench within the active area;
removing the second shield dielectric from the elongated active trench in the multiple shield conductor contact area; and
removing the masking layer thereby leaving the second shield dielectric over the lower shield conductor in the active area.

8. The method of claim 1, wherein:
providing the active trench comprises:
providing an inter-layer dielectric over the upper shield conductor;
providing a gate dielectric along upper sidewalls of the active trench; and
providing a gate electrode within the active trench;
the method further comprises providing a gate contact coupled to the gate electrode;
providing the active trench comprises providing a recessed contact region between the lower shield conductor and the upper shield conductor in the multiple shield conductor contact area;
the gate contact is in the multiple shield conductor contact area; and
the gate contact overlies the recessed contact region in a cross-sectional view.

9. A method of manufacturing a semiconductor device, comprising:
providing a region of semiconductor material comprising:
a top side;
an edge region adjacent to the top side;
a multiple shield conductor contact area;
an active area adjacent the top side; and
an upper shield contact area adjacent to the top side and external to the multiple shield conductor contact area;
providing an active trench extending from the top side into the region of semiconductor material, wherein:
the active trench comprises:
a lower shield conductor;
a first shield dielectric isolating the lower shield conductor from the region of semiconductor material;
an upper shield conductor; and
a second shield dielectric isolating the lower shield conductor from the upper shield conductor within the active area;
the active trench laterally extends within the region of semiconductor material from the active area into the multiple shield conductor contact area; and
the lower shield conductor and the upper shield conductor are coupled together in the multiple shield conductor contact area;
providing a termination trench extending from the top side into a second portion of the region of semiconductor material, wherein:
the termination trench comprises:
the lower shield conductor;
the first shield dielectric isolating the lower shield conductor from the region of semiconductor material;
the upper shield conductor; and
the second shield dielectric isolating the lower shield conductor from the upper shield conductor within the active area;
the termination trench laterally extends within the region of semiconductor material from the active area into the multiple shield conductor contact area; and
the lower shield conductor and the upper shield conductor are coupled together in the multiple shield conductor contact area; and
providing a shield contact in the upper shield contact area coupled to the upper shield conductor in the active trench.

10. The method of claim 9, further comprising:
providing a second shield contact coupled to the upper shield conductor in the termination trench and external to the multiple shield conductor contact area.

11. The method of claim 9, wherein:
providing the active trench and the termination trench comprises:
providing the lower shield conductor within the active trench and the termination trench;
providing a conductive material within the active trench and the termination trench above the lower shield conductor;
removing a first portion of the conductive material within the active trench and the termination trench;
after removing the first portion, providing a masking layer over the conductive material in the termination trench; and
removing a second portion of the conductive material in the active trench to provide the upper shield conductor in the active trench.

12. The method of claim 9, wherein providing the active trench comprises:
providing the active trench as an elongated active trench comprising a tip portion within the multiple shield conductor contact area;
providing the first shield dielectric within the elongated active trench;
providing the lower shield conductor over the first shield dielectric;
providing the second shield dielectric over the lower shield conductor;
providing a masking layer comprising a negative photoresist and an opening,
wherein:
the opening exposes the second shield dielectric in a first portion of the elongated active trench in the multiple shield conductor contact area; and
the masking layer covers a second portion of the elongated active trench within the active area;
removing the second shield dielectric from the elongated active trench in the multiple shield conductor contact area; and
removing the masking layer thereby leaving the second shield dielectric over the lower shield conductor in the active area.

13. A semiconductor device, comprising:
a region of semiconductor material comprising:
a top side;
an edge region;
a multiple shield conductor contact area;
an active area; and
an upper shield contact area external to the multiple shield conductor contact area;
an active trench extending from the top side into the region of semiconductor material, wherein:
the active trench comprises:
a lower shield conductor;
a first shield dielectric isolating the lower shield conductor from the region of semiconductor material;
an upper shield conductor; and
a second shield dielectric isolating the lower shield conductor from the upper shield conductor within the active area;
the active trench laterally extends within the region of semiconductor material from the active area into the multiple shield conductor contact area; and
the lower shield conductor and the upper shield conductor are coupled
together in the multiple shield conductor contact area;
providing a termination trench extending from the top side into a second portion of the region of semiconductor material, wherein:
the termination trench comprises:
the lower shield conductor;
the first shield dielectric isolating the lower shield conductor from the region of semiconductor material;
the upper shield conductor; and
the second shield dielectric isolating the lower shield conductor from the upper shield conductor within the active area;
the termination trench laterally extends within the region of semiconductor material from the active area into the multiple shield conductor contact area; and
the lower shield conductor and the upper shield conductor are coupled together in the multiple shield conductor contact area; and
a shield contact in the upper shield contact area coupled to the upper shield conductor in the active trench.

14. The semiconductor device of claim 13, further comprising:
a second shield contact external to the multiple shield conductor contact area and coupled to the upper shield conductor in the termination trench;
wherein:
the multiple shield conductor contact area is in the edge region; and
the multiple shield conductor contact area is devoid of any shield contacts contacting an upper surface of the upper shield conductor.

15. The semiconductor device of claim 13, further comprising:
a termination trench extending from the top side into a second portion of the region of semiconductor material;
wherein:
the termination trench comprises:
the lower shield conductor;
the first shield dielectric isolating the lower shield conductor from the region of semiconductor material;
the upper shield conductor; and
the second shield dielectric isolating the lower shield conductor from the upper shield conductor within the active area;
the termination trench laterally extends within the region of semiconductor material from the active area into the multiple shield conductor contact area; and
the lower shield conductor and the upper shield conductor are coupled together in the multiple shield conductor contact area.

## Amended claims

### Amended claims in accordance with Rule 137(2) EPC.

1. A method of manufacturing a semiconductor device (10), comprising:
providing a region of semiconductor material (11) comprising:
a top side (18);
an edge region (101);
a multiple shield conductor contact area (102) within the edge region (101);
an active area (103); and
an upper shield contact area (104);
providing an active trench (22A) extending from the top side (18) into the region of semiconductor material (11), wherein:
the active trench (22A) comprises:
a lower shield conductor (21A);
a first shield dielectric (24) isolating the lower shield conductor (21A) from the region of semiconductor material (11);
an upper shield conductor (21B); and
a second shield dielectric (240) isolating the lower shield conductor (21A) from the upper shield conductor (21B) within the active area (103);
the active trench (22A) laterally extends within the region of semiconductor material (11) from the active area (103) into the multiple shield conductor contact area (102); and
the lower shield conductor (21A) and the upper shield conductor (21B) are coupled together in the multiple shield conductor contact area (102); and
providing a shield contact (210A) in the upper shield contact area (104) coupled to the upper shield conductor (21B) in the active trench (22A).

2. The method of claim 1, wherein:
providing the active trench (22A) comprises providing a recessed contact region (212) between the lower shield conductor (21A) and the upper shield conductor (21B) in the multiple shield conductor contact area (102).

3. The method of claim 1, wherein:
providing the region of semiconductor material (11) comprises providing the multiple shield conductor contact area (102) devoid of any shield contacts (210A) contacting an upper surface of the upper shield conductor (21B).

4. The method of claim 1, further comprising:
providing a termination trench (22B) extending from the top side (18) into a second portion of the region of semiconductor material (11), wherein:
the termination trench (22B) comprises:
the lower shield conductor (21A);
the first shield dielectric (24) isolating the lower shield conductor (21A) from the region of semiconductor material (11);
the upper shield conductor (21B); and
the second shield dielectric (240) isolating the lower shield conductor (21A) from the upper shield conductor (21B) within the active area (103);
the termination trench (22B) laterally extends within the region of semiconductor material (11) from the active area (103) into the multiple shield conductor contact area (102); and
the lower shield conductor (21A) and the upper shield conductor (21B) are coupled together in the multiple shield conductor contact area (102).

5. The method of claim 4, further comprising:
providing a second shield contact (210B) external to the multiple shield conductor contact area (102) coupled to the upper shield conductor (21B) in the termination trench (22B).

6. The method of claim 4, wherein:
providing the active trench (22A) and the termination trench (22B) comprises:
providing the lower shield conductor (21A) within the active trench (22A) and the termination trench (22B);
providing a conductive material (211B) within the active trench (22A) and the termination trench (22B) above the lower shield conductor (21A);
removing a first portion of the conductive material (211B) within the active trench (22A) and the termination trench (22B);
providing a masking layer (53) over the conductive material (211B) in the termination trench (22B); and
removing a second portion of the conductive material (211B) in the active trench (22A) to provide the upper shield conductor (21B) in the active trench (22A).

7. The method of claim 1, wherein providing the active trench (22A) comprises:
providing the active trench (22A) as an elongated active trench (22A) comprising a tip portion within the multiple shield conductor contact area (102);
providing the first shield dielectric (24) within the elongated active trench (22A);
providing the lower shield conductor (21A) over the first shield dielectric (24);
providing the second shield dielectric (240) over the lower shield conductor (21A);
providing a masking layer (53) comprising a negative photoresist and an opening,
wherein:
the opening exposes the second shield dielectric (240) in a first portion of the elongated active trench (22A) in the multiple shield conductor contact area (102); and
the masking layer (53) covers a second portion of the elongated active trench (22A) within the active area (103);
removing the second shield dielectric (240) from the elongated active trench (22A) in the multiple shield conductor contact area (102); and
removing the masking layer (53) thereby leaving the second shield dielectric (240) over the lower shield conductor (21A) in the active area (103).

8. The method of claim 1, wherein:
providing the active trench (22A) comprises:
providing an inter-layer dielectric (27) over the upper shield conductor (21B);
providing a gate dielectric (26) along upper sidewalls of the active trench (22A); and
providing a gate electrode (28) within the active trench (22A);
the method further comprises providing a gate contact (280) coupled to the gate electrode (28);
providing the active trench (22A) comprises providing a recessed contact region (212) between the lower shield conductor (21A) and the upper shield conductor (21B) in the multiple shield conductor contact area (102);
the gate contact (280) is in the multiple shield conductor contact area (102); and
the gate contact (280) overlies the recessed contact region (212) in a cross-sectional view.

9. The method of claim 4, wherein providing the active trench (22A) comprises:
providing the active trench (22A) as an elongated active trench comprising a tip portion within the multiple shield conductor contact area (102);
providing the first shield dielectric (24) within the elongated active trench;
providing the lower shield conductor (21A) over the first shield dielectric (24);
providing the second shield dielectric (240) over the lower shield conductor (21A);
providing a masking layer (53) comprising a negative photoresist and an opening,
wherein:
the opening exposes the second shield dielectric (240) in a first portion of the elongated active trench in the multiple shield conductor contact area (102); and
the masking layer (53) covers a second portion of the elongated active trench within the active area (103);
removing the second shield dielectric (240) from the elongated active trench in the multiple shield conductor contact area (102); and
removing the masking layer (53) thereby leaving the second shield dielectric (240) over the lower shield conductor (21A) in the active area (103).

10. A semiconductor device, comprising:
a region of semiconductor material (11) comprising:
a top side (18);
an edge region (101);
a multiple shield conductor contact area (102);
an active area (103); and
an upper shield contact area (104) external to the multiple shield conductor contact area (102);
an active trench (22A) extending from the top side (18) into the region of semiconductor material (11), wherein:
the active trench (22A) comprises:
a lower shield conductor (21A);
a first shield dielectric (24) isolating the lower shield conductor (21A) from the region of semiconductor material (11);
an upper shield conductor (21B); and
a second shield dielectric (240) isolating the lower shield conductor (21A) from the upper shield conductor (21B) within the active area (103);
the active trench (22A) laterally extends within the region of semiconductor material (11) from the active area (103) into the multiple shield conductor contact area (102); and
the lower shield conductor (21A) and the upper shield conductor (21B) are coupled together in the multiple shield conductor contact area (102); and
a shield contact (210A) in the upper shield contact area (104) coupled to the upper shield conductor (21B) in the active trench (22A).

11. The semiconductor device of claim 10, further comprising a termination (22B) trench extending from the top side (18) into a second portion of the region of semiconductor material (11), wherein:
the termination trench (22B) comprises:
the lower shield conductor (21A);
the first shield dielectric (24) isolating the lower shield conductor (21A) from the region of semiconductor material (11);
the upper shield conductor (21B); and
the second shield dielectric (240) isolating the lower shield conductor (21A) from the upper shield conductor (21B) within the active area (103);
the termination trench (22B) laterally extends within the region of semiconductor material (11) from the active area (103) into the multiple shield conductor contact area (102); and
the lower shield conductor (21A) and the upper shield conductor (21B) are coupled together in the multiple shield conductor contact area (102).

12. The semiconductor device of claim 10 or 11, further comprising:
a second shield contact (210B) external to the multiple shield conductor contact area (102) and coupled to the upper shield conductor (21B) in the termination trench (22B);
wherein:
the multiple shield conductor contact area (102) is in the edge region (101); and
the multiple shield conductor contact area (102) is devoid of any shield contacts contacting an upper surface of the upper shield conductor (21B).

13. The semiconductor device of claim 10 or 11, further comprising:
a termination trench (22B) extending from the top side (18) into a second portion of the region of semiconductor material (11);
wherein:
the termination trench (22B) comprises:
the lower shield conductor (21A);
the first shield dielectric (24) isolating the lower shield conductor (21A) from the region of semiconductor material (11);
the upper shield conductor (21B); and
the second shield dielectric (240) isolating the lower shield conductor (21A) from the upper shield conductor (21B) within the active area (103);
the termination trench (22B) laterally extends within the region of semiconductor material (11) from the active area (103) into the multiple shield conductor contact area (102); and
the lower shield conductor (21A) and the upper shield conductor (21B) are coupled together in the multiple shield conductor contact area (102).
